(19) **Europäisches Patentamt**
**European Patent Office**
**Office européen des brevets**

(11) **EP 4 383 151 A1**

(12) **EUROPEAN PATENT APPLICATION**
published in accordance with Art. 153(4) EPC

(43) Date of publication:
**12.06.2024 Bulletin 2024/24**

(21) Application number: **22863357.4**

(22) Date of filing: **29.08.2022**

(51) International Patent Classification (IPC):
**G06N 20/00** (2019.01)          **G06N 20/20** (2019.01)
**G06F 30/27** (2020.01)

(52) Cooperative Patent Classification (CPC):
**G06F 30/27; G06N 20/00; G06N 20/20;**
**H04W 24/02; H04W 88/08**

(86) International application number:
**PCT/CN2022/115402**

(87) International publication number:
**WO 2023/030221 (09.03.2023 Gazette 2023/10)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **30.08.2021 CN 202111005070**

(71) Applicant: **Huawei Technologies Co., Ltd.**
**Shenzhen, Guangdong 518129 (CN)**

(72) Inventors:
- **CHAI, Xiaomeng**
  **Shenzhen, Guangdong 518129 (CN)**
- **SUN, Yan**
  **Shenzhen, Guangdong 518129 (CN)**
- **WU, Yiqun**
  **Shenzhen, Guangdong 518129 (CN)**

(74) Representative: **Körber, Martin Hans et al**
**Mitscherlich PartmbB**
**Patent- und Rechtsanwälte**
**Karlstraße 7**
**80333 München (DE)**

(54) **COMMUNICATION METHOD AND APPARATUS**

(57)     This disclosure relates to a communication method and apparatus. The method includes: An access network device receives M pieces of first information of M local models from M terminal devices, where the M terminal devices one-to-one correspond to the M local models, the M local models one-to-one correspond to the M pieces of first information, and the M pieces of first information of the M local models are information received in first duration. The access network device updates a global model based on the M pieces of first information of the M local models, and sends first information of the global model to K terminal devices. In the method, the first duration is set, to ensure that an update progress of local information matches an update progress of the global model, and improve accuracy and performance of the global model obtained by the access network device.

FIG. 3

**Description**

**CROSS-REFERENCE TO RELATED APPLICATIONS**

This application claims priority to Chinese Patent Application No. 202111005070.2, filed with the China National Intellectual Property Administration on August 30, 2021 and entitled "COMMUNICATION METHOD AND APPARATUS", which is incorporated herein by reference in its entirety.

**TECHNICAL FIELD**

This disclosure relates to the field of communication technologies, and in particular, to a communication method and apparatus.

**BACKGROUND**

In a wireless communication network, for example, in a mobile communication network, services supported by the network are increasingly diversified, and therefore requirements that need to be met are increasingly diversified. For example, the network needs to be able to support ultra-high rates, ultra-low latency, and/or ultra-large connections. This feature makes network planning, network configuration, and/or resource scheduling increasingly complex. In addition, because a network function is increasingly powerful, for example, supporting an increasingly high spectrum and supporting new technologies such as a high-order multiple-input multiple-output (multiple-input multiple-output, MIMO) technology, beamforming, and/or beam management, network energy saving becomes a hot research topic. These new requirements, scenarios, and features bring unprecedented challenges to network planning, operation and maintenance, and efficient operation. To meet this challenge, an artificial intelligence technology may be introduced into a wireless communication network, to implement network intelligence. Based on this, how to effectively implement artificial intelligence in a network is a problem worth studying.

**SUMMARY**

This disclosure provides a communication method and apparatus, to improve performance of a model obtained through training.

According to a first aspect, a first communication method is provided, and the method may be performed on an access network device side. The method may be performed by using software, hardware, or a combination of software and hardware. For example, the method is performed by an access network device, or is performed by a large device including the access network device, or is performed by a circuit system. The circuit system can implement a function of the access network device, or is performed by an AI module independent of the access network device with assistance of the access network device or a network element that assists the access network device. This is not limited. For example, the access network device is an access network device such as a base station. The method includes: receiving M pieces of first information of M local models from M terminal devices, where the M terminal devices one-to-one correspond to the M local models, the M local models one-to-one correspond to the M pieces of first information, the M pieces of first information of the M local models are information received in first duration, and M is a positive integer; and sending first information of a global model to K terminal devices, where K is a positive integer, the first information of the global model is information obtained after the global model is updated, and the M pieces of first information of the M local models are used to update the global model.

In this disclosure, for example, the first duration is used in one round of training process. If first information of a local model is received in the first duration, it indicates that the first information of the local model is available, and the access network device may use the first information of the local model, for example, obtain the first information of the global model based on the first information of the local model. However, if first information of some local models is received beyond the first duration (for example, before a start of the first duration or after an end of the first duration), the first information of the local models may be considered as outdated information, and the access network device may not consider the first information of the local models when obtaining the first information of the global model. This can ensure as much as possible that an update progress of local information matches an update progress of the global model, and improve accuracy and performance of the global model obtained by the access network device.

In an optional implementation, the method further includes: updating the global model based on the M pieces of first information of the M local models. The access network device selects, by using the first duration, the M pieces of first information that meet a condition, so that the global model can be updated based on the M pieces of first information, and an update progress of the local model matches the update progress of the global model. After the global model is updated, the first information of the global model may be obtained, so that the access network device can send the first information of the global model.

In an optional implementation, the method further includes: receiving N pieces of first information of N local models, where the N pieces of first information of the N local models are information received beyond the first duration, and N is a positive integer; and discarding the N pieces of first information of the N local models, or skipping using the N pieces of first information of the N local models to update the global model. "Beyond the first duration", for example, is understood as "after the first duration expires" or "before the first duration starts". In other words, the N pieces of first information are received after the first duration expires or before the first duration starts. In this case, the first information is considered as unavailable information, and the access network device may not consider the N pieces of first information when obtaining the first information of the global model, so that outdated information does not affect performance of the global model. For example, the access network device may discard the N pieces of first information. Alternatively, if the N pieces of first information have other purposes, the access network device may not discard the N pieces of first information, provided that the N pieces of first information do not participate in updating the global model.

In an optional implementation, a start moment of the first duration is the $H1^{th}$ time unit after a time unit in which second information of the global model is sent last time starts, or a start moment of the first duration is a time unit in which training of the global model starts, a length of the first duration is H2 time units, H1 is greater than or equal to 0, and H2 is greater than 0. For example, initial information of the global model is preconfigured in UE and the access network device, or the initial information of the global model is predefined by a protocol. When training of the global model starts, the access network device may not need to send the initial information of the global model. In a first round of training process, there may be no process in which the access network device sends the second information (for example, the initial information of the global model) of the global model last time. In this case, the start moment of the first duration may be a time unit in which training of the global model starts. In addition, for another round of training process, or for a solution in which the initial information of the global model needs to be sent by the access network device, there is a process in which the access network device sends the second information of the global model last time. It may be understood that, if there is a process in which the access network device sends the second information of the global model last time, the start moment of the first duration may be the $H1^{th}$ time unit after a time unit in which the access network device sends the second information of the global model last time starts, or the start moment of the first duration may be a time unit in which training of the global model starts. If there is no process in which the access network device sends the second information of the global model last time, the start moment of the first duration may be a time unit in which training of the global model starts.

In an optional implementation, H1 and/or H2 may be predefined by a protocol, and do not need to be configured by the access network device. This can reduce signaling interaction between the access network device and the terminal device, and reduce a workload of the access network device. Alternatively, H1 and/or H2 may be preconfigured, for example, preconfigured by the access network device, or preconfigured by another device. This manner is flexible. The access network device or another device configures H1 and/or H2 based on a network condition. Alternatively, H1 may be predefined by a protocol, and H2 is preconfigured by the access network device or another device. Alternatively, H2 may be predefined by a protocol, and H1 is preconfigured by the access network device or another device. This is not limited in this disclosure.

In an optional implementation, first information of a first local model is all or a part of information corresponding to the first local model, the first information of the first local model is included in the M pieces of first information of the M local models, and the first local model corresponds to a first terminal device in the M terminal devices. For example, parameter information indicated by the first information of the first local model may include all parameter information of the first local model, or include a part of parameter information of the first local model. In other words, when performing training, the terminal device may train all parameters of the global model, or may train a part of parameters of the global model. For example, a part of parameters of the global model are updated quickly, and a part of parameters are updated slowly. The terminal device may not need to train a parameter that is updated slowly in each round. Therefore, an update requirement of the global model can be met, and a training workload can be reduced, to improve training efficiency.

In an optional implementation, the first information of the first local model in the M pieces of first information of the M local models is from the first terminal device in the M terminal devices. The first information of the first local model indicates parameter information of the first local model; or the first information of the first local model indicates a difference between the parameter information of the first local model and first parameter information. The first parameter information is parameter information that is of the global model and that is indicated to the first terminal device last time (or the first parameter information is a difference between parameter information obtained by the terminal device this time and parameter information of the first local model reported by the terminal device last time), or is parameter information of the global model before the global model is updated. The first information of the first local model may indicate the parameter information of the first local model. In this way, the access network device can directly obtain the parameter information of the first local model without other processing, to reduce a workload of the access network device. Alternatively, the first information of the first local model may indicate a corresponding difference. Compared with actual parameter information, the difference may have a smaller information amount, and therefore, fewer resource overheads are occupied for sending the difference, to save transmission resources.

In an optional implementation, the first information of the global model indicates parameter information of the global model, or the first information of the global model indicates a difference between second parameter information (or current parameter information) of the global model and the first parameter information, and the first parameter information is parameter information that is of the global model and that is indicated last time or parameter information of the global model before the global model is updated. The first information of the global model may indicate the parameter information of the global model. In this way, the terminal device can directly obtain the parameter information of the global model without other processing, to reduce a workload of the terminal device. Alternatively, the first information of the global model may be reflected by using a difference. Compared with actual parameter information, the difference may have a smaller information amount, and therefore, fewer resource overheads are occupied for sending the difference, to save transmission resources.

In an optional implementation, a part or all of the K terminal devices are included in one terminal device group. In some scenarios, distribution of local data (for example, training data used to train the global model) of different terminal devices varies greatly. When the terminal devices train a model in a distributed manner, it may be difficult for the model to converge. In this case, the terminal devices may be grouped, terminal devices whose local data is distributed similarly are grouped into one group, and each group of terminal devices train one global model in a distributed manner. In this case, the access network device may maintain a plurality of global models, and different global models correspond to different terminal device groups. For example, the K terminal devices are a part or all of terminal devices in one group. Different groups separately train different global models, so that the global model can be converged more quickly, and training efficiency is improved.

In an optional implementation, values of fourth parameters corresponding to terminal devices included in the terminal device group all fall within a first range, and the first range corresponds to the global model; or a difference between a value of a fourth parameter corresponding to a terminal device included in the terminal device group and a first value is less than or equal to a first threshold, and the first value corresponds to the global model. For example, the terminal devices may be grouped into different terminal device groups by using the fourth parameters. This grouping manner is simple, and may be performed by the access network device, or may be performed by the terminal devices.

According to a second aspect, a second communication method is provided, and the method may be performed on an access network device side. The method may be performed by using software, hardware, or a combination of software and hardware. For example, the method is performed by an access network device, or is performed by a large device including the access network device, or is performed by a circuit system. The circuit system can implement a function of the access network device, or is performed by an AI module independent of the access network device with assistance of the access network device or a network element that assists the access network device. This is not limited. For example, the access network device is an access network device such as a base station. The method includes: receiving M pieces of first information of M local models from M terminal devices, where the M terminal devices one-to-one correspond to the M local models, the M local models one-to-one correspond to the M pieces of first information, first information of each local model corresponds to a first counter, and a value of each first counter matches a value of a second counter; and sending first information of a global model to K terminal devices, where K is a positive integer, the first information of the global model is information obtained after the global model is updated, the M pieces of first information of the M local models are used to update the global model, and the second counter is a counter corresponding to the global model. Alternatively, the method includes: updating a global model based on M pieces of available first information of M local models, where the M local models one-to-one correspond to the M pieces of first information, available first information of each local model corresponds to a first counter, and a value of each first counter matches a value of a second counter; and sending first information of the global model to K terminal devices, where K is a positive integer.

The M pieces of available first information of the M local models may be understood as the M pieces of available first information. That is, "available" means that the "first information" is available. Alternatively, the M pieces of available first information of the M local models may be understood as the M pieces of first information of the M available local models. That is, "available" means that the "local model" is available. If a value of a first counter of a piece of local information matches the value of the second counter, it indicates that the local information is available, and the access network device may use the local information, for example, obtain the first information of the global model based on the first information of the local model indicated by the local information. However, if a value of a first counter of some local information does not match the value of the second counter, the local information may be considered as outdated information, and the access network device may not consider the local information when obtaining the first information of the global model. In this way, it can be ensured that the local model matches an update progress of the global model, an outdated local model does not affect performance of the global model, and accuracy and performance of the global model obtained by the access network device are improved.

In an optional implementation, the method further includes: sending information about the second counter to the K terminal devices. The access network device may send the information about the second counter (for example, the value of the second counter) to the terminal device, and the terminal device may update the value of the first counter based on the information about the second counter, so that the first counter of the terminal device and the second counter of the access network device are synchronously updated and can match each other.

In an optional implementation, first information of a first local model is all or a part of information corresponding to the first local model, the first information of the first local model is included in the M pieces of first information of the M local models, and the first local model corresponds to a first terminal device in the M terminal devices.

In an optional implementation, the first local information corresponding to the first local model further indicates an identifier of first information of the first local model. Because the first information of the first local model may be a part of information corresponding to the first local model, the first local information may further indicate the identifier of the first information of the first local model, so that the access network device can determine the part of information of the first local model.

In an optional implementation, the first information of the first local model in the M pieces of first information of the M local models is from the first terminal device in the M terminal devices. The first information of the first local model indicates parameter information of the first local model; or the first information of the first local model indicates a difference between the parameter information of the first local model and first parameter information, and the first parameter information is parameter information corresponding to information that is of the global model and that is indicated to the first terminal device last time or parameter information of the global model before the global model is updated.

In an optional implementation, the first information of the global model indicates parameter information of the global model, or the first information of the global model indicates a difference between second parameter information (or current parameter information) of the global model and the first parameter information, and the first parameter information is parameter information that is of the global model and that is indicated to the first terminal device last time or parameter information of the global model before the global model is updated.

In an optional implementation, a part or all of the K terminal devices are included in one terminal device group.

In an optional implementation, values of fourth parameters corresponding to terminal devices included in the terminal device group all fall within a first range, and the first range corresponds to the global model; or a difference between a value of a fourth parameter corresponding to a terminal device included in the terminal device group and a first value is less than or equal to a first threshold, and the first value corresponds to the global model.

For technical effects brought by some optional implementations of the second aspect, refer to the description of the technical effects brought by the first aspect or corresponding implementations.

According to a third aspect, a third communication method is provided, and the method may be performed on a terminal device side. The method may be performed by using software, hardware, or a combination of software and hardware. For example, the method is performed by a terminal device, or is performed by a circuit system, or is performed by a large device including the terminal device. The circuit system can implement a function of the terminal device. The method includes: performing training by using a global model, to obtain first information of a first local model; sending the first information of the first local model to an access network device in first duration; and receiving first information of the global model from the access network device, where the first information of the global model is information obtained after the global model is updated.

In an optional implementation, the method further includes: receiving second information of the global model, where the second information of the global model is information before the global model is updated. The second information of the global model is, for example, information obtained after the global model is updated in a previous round of training process. The access network device sends the second information of the global model to the terminal device, and the terminal device may perform training by using the second information of the global model. Alternatively, the first information of the global model is, for example, information obtained after the global model is updated in the first round of training process. The second information of the global model is, for example, initial information of the global model, and the access network device may send the initial information of the global model to the terminal device. Alternatively, in another case, the initial information of the global model may be predefined by a protocol, or may be preconfigured in the access network device and the terminal device. In this case, the access network device may not need to send the initial information of the global model. In this case, if the second information of the global model is the initial information of the global model, the access network device does not need to send the second information of the global model, and the terminal device does not receive the second information of the global model, either.

For description of the first duration, the first information of the first local model, the first information of the global model, and the like, refer to the first aspect. Details are not described herein again.

In an optional implementation, the method further includes: determining that a value of a fourth parameter falls within a first range, where the first range corresponds to the global model; or determining that a difference between the value of the fourth parameter and a first value is less than or equal to a first threshold, where the first value corresponds to the global model; or determining, based on a classification network, that a first terminal device belongs to a first class, where the first class is applicable to the global model.

For technical effects brought by the third aspect or the optional implementations, refer to description of the technical effects brought by the first aspect or the corresponding implementations.

According to a fourth aspect, a fourth communication method is provided, and the method may be performed on a terminal device side. The method may be performed by using software, hardware, or a combination of software and hardware. For example, the method is performed by a terminal device, or is performed by a circuit system, or is performed by a large device including the terminal device. The circuit system can implement a function of the terminal device. The method includes: performing training by using a global model, to obtain first information of a first local model; sending first local information to an access network device, where the first local information indicates the first information of the first local model and indicates a first counter, and the first counter identifies the first local model; and receiving first information of the global model from the access network device, where the first information of the global model is information obtained after the global model is updated.

For description of the first counter, the first information of the first local model, the first information of the global model, and the like, refer to the first aspect. Details are not described herein again.

In an optional implementation, the method further includes: receiving second information of the global model, where the second information of the global model is information before the global model is updated.

In an optional implementation, the method further includes: receiving information about a second counter from the access network device; and updating a value of the first counter to a value of the second counter.

In an optional implementation, the method further includes: determining that a value of a fourth parameter falls within a first range, where the first range corresponds to the global model; or determining that a difference between the value of the fourth parameter and a first value is less than or equal to a first threshold, where the first value corresponds to the global model; or determining, based on a classification network, that a first terminal device belongs to a first class, where the first class is applicable to the global model.

For technical effects brought by the fourth aspect or the optional implementations, refer to description of the technical effects brought by the second aspect or the corresponding implementations.

According to a fifth aspect, a communication apparatus is provided. The communication apparatus may implement the method according to the first aspect or the second aspect. The communication apparatus has a function of the access network device. The access network device is, for example, a base station, or a baseband apparatus in the base station. In an optional implementation, the apparatus may include modules that one-to-one correspond to the methods/operations/steps/actions described in the first aspect or the second aspect. The module may be a hardware circuit, or may be software, or may be implemented by a combination of a hardware circuit and software. In an optional implementation, the communication apparatus includes a baseband apparatus and a radio frequency apparatus. In another optional implementation, the communication apparatus includes a processing unit (also referred to as a processing module sometimes) and a transceiver unit (also referred to as a transceiver module sometimes). The transceiver unit can implement a sending function and a receiving function. When the transceiver unit implements the sending function, the transceiver unit may be referred to as a sending unit (also referred to as a sending module sometimes). When the transceiver unit implements the receiving function, the transceiver unit may be referred to as a receiving unit (also referred to as a receiving module sometimes). The sending unit and the receiving unit may be one functional module, and the functional module is referred to as the transceiver unit. The functional module can implement the sending function and the receiving function. Alternatively, the sending unit and the receiving unit may be different functional modules, and the transceiver unit is a collective term for the functional modules.

The transceiver unit (or the receiving unit) is configured to receive M pieces of first information of M local models from M terminal devices, where the M terminal devices one-to-one correspond to the M local models, the M local models one-to-one correspond to the M pieces of first information, the M pieces of first information of the M local models are information received in first duration, and M is a positive integer. The transceiver unit (or the sending unit) is further configured to send first information of a global model to K terminal devices, where K is a positive integer, the first information of the global model is information obtained after the global model is updated, and the M pieces of first information of the M local models are used to update the global model.

Alternatively, the processing unit is configured to obtain first information of a global model based on M pieces of available first information of M local models, where the M local models one-to-one correspond to the M pieces of first information, the M pieces of available first information of the M local models are information received in first duration, and M is a positive integer. The transceiver unit (or the sending unit) is configured to send the first information of the global model to K terminal devices, where K is a positive integer.

Alternatively, the transceiver unit (or the receiving unit) is configured to receive M pieces of first information of M local models from M terminal devices, where the M terminal devices one-to-one correspond to the M local models, the M local models one-to-one correspond to the M pieces of first information, first information of each local model corresponds to a first counter, and a value of each first counter matches a value of a second counter. The transceiver unit (or the sending unit) is further configured to send first information of a global model to K terminal devices, where K is a positive integer, the first information of the global model is information obtained after the global model is updated, the M pieces of first information of the M local models are used to update the global model, and the second counter is a counter corresponding to the global model.

Alternatively, the processing unit is configured to update a global model based on M pieces of available first information of M local models, where the M local models one-to-one correspond to the M pieces of first information, available first information of each local model corresponds to a first counter, and a value of each first counter matches a value of a second counter. The transceiver unit (or the sending unit) is configured to send first information of the global model to K terminal devices, where K is a positive integer.

For another example, the communication apparatus includes a processor, coupled to a memory, and configured to execute instructions in the memory, to implement the method in the first aspect or the second aspect. Optionally, the communication apparatus further includes another component, for example, an antenna, an input/output module, and an interface. These components may be hardware, software, or a combination of software and hardware.

According to a sixth aspect, a communication apparatus is provided. The communication apparatus may implement the method according to the third aspect or the fourth aspect. The communication apparatus has a function of the terminal device. In an optional implementation, the apparatus may include modules that one-to-one correspond to the methods/operations/steps/actions described in the third aspect or the fourth aspect. The module may be a hardware circuit, or may be software, or may be implemented by a combination of a hardware circuit and software. In an optional implementation, the communication apparatus includes a baseband apparatus and a radio frequency apparatus. In another optional implementation, the communication apparatus includes a processing unit (also referred to as a processing module sometimes) and a transceiver unit (also referred to as a transceiver module sometimes). For an implementation of the transceiver unit, refer to related description in the fifth aspect.

The processing unit is configured to perform training by using a global model, to obtain first information of a first local model. The transceiver unit (or the sending unit) is configured to send the first information of the first local model to an access network device in first duration. The transceiver unit (or the receiving unit) is configured to receive first information of the global model from the access network device, where the first information of the global model is information obtained after the global model is updated.

Alternatively, the processing unit is configured to perform training by using a global model, to obtain first information of a first local model. The transceiver unit (or the sending unit) is configured to send first local information to an access network device, where the first local information indicates the first information of the first local model and indicates a first counter, and the first counter identifies the first local model. The transceiver unit (or the receiving unit) is configured to receive first information of the global model from the access network device, where the first information of the global model is information obtained after the global model is updated.

For another example, the communication apparatus includes a processor, coupled to a memory, and configured to execute instructions in the memory, to implement the method in the third aspect or the fourth aspect. Optionally, the communication apparatus further includes another component, for example, an antenna, an input/output module, and an interface. These components may be hardware, software, or a combination of software and hardware.

According to a seventh aspect, a computer-readable storage medium is provided. The computer-readable storage medium is configured to store a computer program or instructions, and when the computer program or the instructions are run, the method in any one of the first aspect to the fourth aspect is implemented.

According to an eighth aspect, a computer program product including instructions is provided. When the computer program product runs on a computer, the method according to any one of the first aspect to the fourth aspect is implemented.

According to a ninth aspect, a chip system is provided. The chip system includes a processor, and may further include a memory, configured to implement the method in any one of the first aspect to the fourth aspect. The chip system may include a chip, or may include a chip and another discrete component.

According to a tenth aspect, a communication system is provided, including the communication apparatus in the fifth aspect and the communication apparatus in the sixth aspect.

**BRIEF DESCRIPTION OF DRAWINGS**

FIG. 1 is a schematic diagram of a communication system;
FIG. 2A and FIG. 2B are two schematic diagrams of architectures of communication networks;
FIG. 2C is a schematic diagram of an application framework of AI;
FIG. 2D to FIG. 2G are schematic diagrams of several network architectures;
FIG. 3 is a flowchart of a first communication method;
FIG. 4A is a schematic diagram of a neuron structure;
FIG. 4B is a schematic diagram of a layer relationship of a neural network;
FIG. 4C is a schematic diagram in which different UEs correspond to different global models;

FIG. 4D is a schematic diagram of dividing layer sets;

FIG. 5 is a flowchart of a second communication method;

FIG. 6 is a flowchart of an example of combining a first communication method and a second communication method; and

FIG. 7 is a schematic block diagram of a communication apparatus.

## DESCRIPTION OF EMBODIMENTS

To make the objectives, technical solutions, and advantages of this disclosure clearer, the following further describes this disclosure in detail with reference to the accompanying drawings.

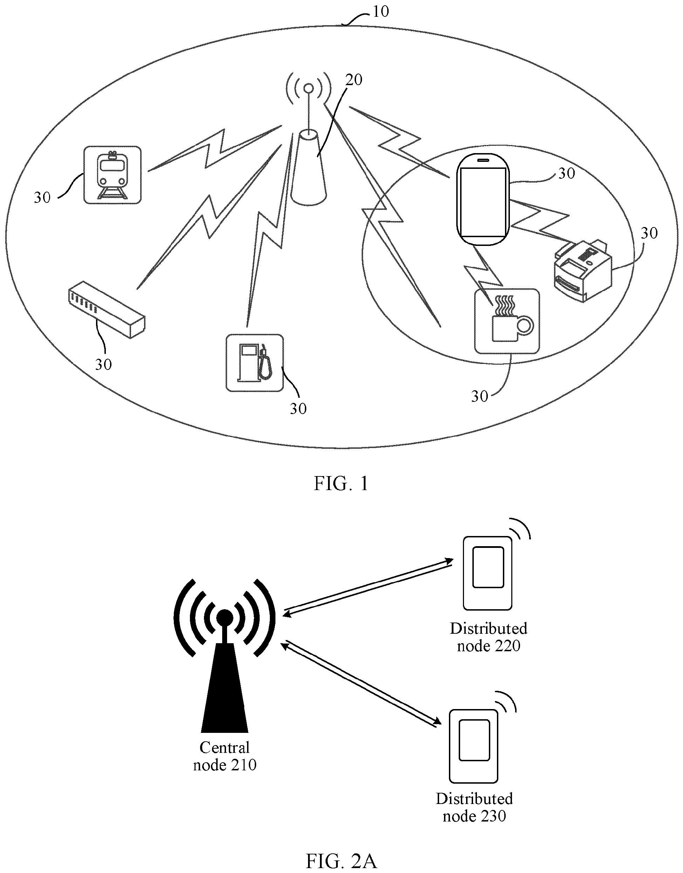

The technology provided in this disclosure may be applied to a communication system 10 shown in FIG. 1. The communication system 10 includes one or more communication apparatuses 30 (for example, a terminal device). The one or more communication apparatuses 30 are connected to one or more core network (core network, CN) devices through one or more radio access network (radio access network, RAN) devices 20, to implement communication between a plurality of communication devices. For example, the communication system 10 is a communication system supporting a 4G (including a long term evolution (long term evolution, LTE)) access technology, a communication system supporting a 5G (sometimes referred to as new radio, NR) access technology, a wireless fidelity (wireless fidelity, Wi-Fi) system, a cellular system related to the 3rd generation partnership project (3rd generation partnership project, 3GPP), a communication system supporting convergence of a plurality of radio technologies, or a future-oriented evolved system.

The following separately describes in detail the terminal device and the RAN in FIG. 1.

1. Terminal device:

The terminal device may be briefly referred to as a terminal. The terminal device may be a device having a wireless transceiver function. The terminal device may be mobile or fixed. The terminal device may be deployed on land, where the deployment includes indoor or outdoor, or handheld or vehicle-mounted deployment, may be deployed on water (for example, on a ship), or may be deployed in air (for example, on an aircraft, a balloon, or a satellite). The terminal device may include a mobile phone (mobile phone), a tablet computer (pad), a computer with a wireless receiving/transmitting function, a virtual reality (virtual reality, VR) terminal device, an augmented reality (augmented reality, AR) terminal device, a wireless terminal device in industrial control (industrial control), a wireless terminal device in self driving (self driving), a wireless terminal device in remote medical (remote medical), a wireless terminal device in a smart grid (smart grid), a wireless terminal device in transportation safety (transportation safety), a wireless terminal device in a smart city (smart city), and/or a wireless terminal device in a smart home (smart home). Alternatively, the terminal device may be a cellular phone, a cordless phone, a session initiation protocol (session initiation protocol, SIP) phone, a wireless local loop (wireless local loop, WLL) station, a personal digital assistant (personal digital assistant, PDA), a handheld device or a computing device with a wireless communication function, a vehicle-mounted device, a wearable device, a terminal device in a 5th generation (5th generation, 5G) network, a terminal device in a future evolved public land mobile network (public land mobile network, PLMN), or the like. The terminal device may also be referred to as user equipment (user equipment, UE) sometimes. Optionally, the terminal device may communicate with a plurality of access network devices that use different technologies. For example, the terminal device may communicate with an access network device that supports LTE, or may communicate with an access network device that supports 5G, or may implement dual connectivity to an access network device that supports LTE and an access network device that supports 5G. This is not limited in this disclosure.

In this disclosure, an apparatus configured to implement a function of a terminal device may be a terminal device, or may be an apparatus that can support the terminal device in implementing the function, for example, a chip system, a hardware circuit, a software module, or a hardware circuit and a software module. The apparatus may be installed in the terminal device or may be matched with the terminal device for usage. In the technical solutions provided in this disclosure, an example in which an apparatus configured to implement a function of a terminal device is a terminal device or UE is used to describe the technical solutions provided in this disclosure.

In this disclosure, the chip system may include a chip, or may include a chip and another discrete component.

2. RAN

The RAN may include one or more RAN devices, for example, a RAN device 20. An interface between the RAN device and the terminal device may be a Uu interface (or referred to as an air interface). In future communication, names of these interfaces may remain unchanged, or may be replaced with other names. This is not limited in this disclosure.

The RAN device is a node or a device that enables the terminal device to access the radio network. The RAN device may also be referred to as an access network device or a network device. For example, the RAN device includes but is not limited to: a base station, a generation NodeB (generation NodeB, gNB) in 5G, an evolved NodeB (evolved NodeB, eNB), a radio network controller (radio network controller, RNC), a NodeB (NodeB, NB), a base station controller (base station controller, BSC), a base transceiver station (base transceiver station, BTS), a home base station (for example, a home evolved NodeB, or a home NodeB, HNB), a baseband unit (base band unit, BBU), a transmitting and receiving point (transmitting and receiving point, TRP), a transmitting point (transmitting point, TP), and/or a mobile switching center. Alternatively, the access network device may be a central unit (central unit, CU), a distributed unit (distributed unit, DU), a central unit control plane (CU control plane, CU-CP) node, or a central unit user plane (CU user plane, CU-UP) node. Alternatively, the access network device may be a relay station, an access point, a vehicle-mounted device, a terminal device, a wearable device, an access network device in a 5G network, an access network device in a future evolved public land mobile network (public land mobile network, PLMN), or the like.

In this disclosure, an apparatus configured to implement a function of the access network device may be an access network device, or may be an apparatus that can support the access network device in implementing the function, for example, a chip system, a hardware circuit, a software module, or a hardware circuit plus a software module. The apparatus may be installed in the access network device or may be matched with the access network device for usage. In the technical solutions provided in this disclosure, an example in which an apparatus configured to implement a function of an access network device is an access network device is used to describe the technical solutions provided in this disclosure.

(1) Protocol layer structure

Communication between an access network device and a terminal device complies with a specified protocol layer structure. The protocol layer structure may include a control plane protocol layer structure and a user plane protocol layer structure. For example, the control plane protocol layer structure may include functions of protocol layers such as a radio resource control (radio resource control, RRC) layer, a packet data convergence protocol (packet data convergence protocol, PDCP) layer, a radio link control (radio link control, RLC) layer, a media access control (media access control, MAC) layer, and a physical layer. For example, the user plane protocol layer structure may include functions of protocol layers such as a PDCP layer, an RLC layer, a MAC layer, and a physical layer. In a possible implementation, a service data adaptation protocol (service data adaptation protocol, SDAP) layer may be further included above the PDCP layer.

Optionally, the protocol layer structure between the access network device and the terminal device may further include an artificial intelligence (artificial intelligence, AI) layer structure, used to transmit data related to an AI function.

(2) Central unit (central unit, CU) and distributed unit (distributed unit, DU)

An RAN device may include a CU and a DU. A plurality of DUs may be centrally controlled by one CU. For example, an interface between the CU and the DU may be referred to as an F1 interface. A control plane (control plane, CP) interface may be F1-C, and a user plane (user plane, UP) interface may be F1-U. The CU and the DU may be divided based on protocol layers of the radio network. For example, functions of the PDCP layer and protocol layers above the PDCP layer are disposed on the CU, and functions of protocol layers below the PDCP layer (for example, the RLC layer and the MAC layer) are disposed on the DU. For another example, functions of protocol layers above the PDCP layer are disposed on the CU, and functions of the PDCP layer and protocol layers below the PDCP layer are disposed on the DU. This is not limited.

It may be understood that, division of processing functions of the CU and the DU based on the protocol layers is merely an example, and the processing functions of the CU and the DU may alternatively be divided in another manner. For example, the CU or the DU may be divided into functions having more protocol layers. For another example, the CU or the DU may be further divided into some processing functions having protocol layers. In a design, some functions of the RLC layer and functions of protocol layers above the RLC layer are configured on the CU, and remaining functions of the RLC layer and functions of protocol layers below the RLC layer are configured on the DU. In another design, division of functions of the CU or the DU may alternatively be performed based on service types or other system requirements. For example, the division may be performed based on latency. Functions whose processing time needs to satisfy a latency requirement are set on the DU, and functions whose processing time does not need to satisfy the latency requirement are set on the CU. In another design, the CU may alternatively have one or more functions of the core network. For example, the CU may be disposed on a network side to facilitate centralized management. In another design, a radio unit (radio unit, RU) of the DU is disposed remotely. Optionally, the RU may have a radio frequency function.

Optionally, the DU and the RU may be further divided at a physical layer (physical layer, PHY). For example, the DU may implement higher-layer functions in the PHY layer, and the RU may implement lower-layer functions in the PHY layer. When the PHY layer is used for sending, functions of the PHY layer may include at least one of the following functions: cyclic redundancy check (cyclic redundancy check, CRC) code adding, channel coding, rate matching, scrambling, modulation, layer mapping, precoding, resource mapping, physical antenna mapping, or radio frequency sending. When the PHY layer is used for receiving, functions of the PHY layer may include at least one of the following: CRC check, channel decoding, de-rate matching, descrambling, demodulation, layer demapping, channel detection, resource demapping, physical antenna demapping, or radio frequency receiving. The higher-layer functions of the PHY layer may include some functions of the PHY layer. For example, the some functions are closer to the MAC layer. The lower-layer functions of the PHY layer may include other functions of the PHY layer. For example, the other functions are closer to the radio frequency function. For example, the higher-layer functions of the PHY layer may include CRC code adding, channel coding, rate matching, scrambling, modulation, and layer mapping, and the lower-layer functions of the PHY layer may include precoding, resource mapping, physical antenna mapping, and radio frequency sending; or the higher-layer functions of the PHY layer may include CRC code adding, channel coding, rate matching, scrambling, modulation, layer mapping, and precoding, and the lower-layer functions of the PHY layer may include resource mapping, physical antenna mapping, and radio frequency sending. For example, the higher-layer functions of the PHY layer may include CRC check, channel decoding, de-rate matching, decoding, demodulation, and layer demapping, and the lower-layer functions of the PHY layer may include channel detection, resource demapping, physical antenna demapping, and radio frequency receiving. Alternatively, the higher-layer functions of the PHY layer may include CRC check, channel decoding, de-rate matching, decoding, demodulation, layer demapping, and channel detection, and the lower-layer functions of the PHY layer may include resource demapping, physical antenna demapping, and radio frequency receiving.

For example, the functions of the CU may be implemented by one entity, or may be implemented by different entities. For example, functions of the CU may be further divided, that is, a control plane and a user plane are separated and implemented by different entities, which are a control plane CU entity (that is, a CU-CP entity) and a user plane CU entity (that is, a CU-UP entity). The CU-CP entity and the CU-UP entity may be coupled to the DU, to jointly complete functions of the RAN device.

In the foregoing network architecture, signaling generated by the CU may be sent to the terminal device by using the DU, or signaling generated by the terminal device may be sent to the CU by using the DU. For example, signaling at the RRC or PDCP layer may be finally processed as signaling at the physical layer and sent to the terminal device, or is converted from signaling received from the physical layer. In this architecture, the RRC or PDCP layer signaling may be considered to be sent through the DU, or sent through the DU and the RU.

Optionally, any one of the DU, the CU, the CU-CP, the CU-UP, and the RU may be a software module, a hardware structure, or a software module plus hardware structure. This is not limited. Different entities may exist in different forms. This is not limited. For example, the DU, the CU, the CU-CP, and the CU-UP are software modules, and the RU is a hardware structure. These modules and methods performed by these modules also fall within the protection scope of this disclosure.

In a possible implementation, the RAN device includes a CU-CP, a CU-UP, a DU, and an RU. For example, the method in this disclosure is performed by a DU, or is performed by a DU and an RU, or is performed by a CU-CP, a DU, and an RU, or is performed by a CU-UP, a DU, and an RU. This is not limited. Methods performed by the modules also fall within the protection scope of this disclosure.

It should be understood that a quantity of devices in the communication system shown in FIG. 1 is merely used as an example, and this disclosure is not limited thereto. In actual application, the communication system may further include more terminal devices and more RAN devices, and may further include another device, for example, may include a core network device and/or a node configured to implement an artificial intelligence function.

The network architecture shown in FIG. 1 may be applicable to communication systems of various radio access technologies (radio access technology, RAT), for example, a 4G communication system, or a 5G (or referred to as new radio (new radio, NR)) communication system, or a transition system between an LTE communication system and the 5G communication system, or a future communication system, for example, a 6G communication system. The transition system may also be referred to as a 4.5G communication system. The network architecture and the service scenario described in this disclosure are intended to describe the technical solutions in this disclosure more clearly, and do not constitute a limitation on the technical solutions provided in this disclosure. A person of ordinary skill in the art may know that, with evolution of the network architecture and emergence of new service scenarios, the technical solutions provided in this disclosure are also applicable to similar technical problems.

In addition to communication between the access network device and the terminal device, the method provided in this disclosure may also be used for communication between other communication devices, for example, communication between a macro base station and a micro base station in a wireless backhaul link, for example, communication between a first terminal device and a second terminal device in a sidelink (sidelink, SL). This is not limited. This disclosure is described by using communication between the access network device and the terminal device as an example.

The method provided in this disclosure relates to machine learning. The machine learning may be implemented by using various possible technologies, for example, by using a neural network (neural network, NN). A neural network is a specific implementation form of a machine learning technology. According to a universal approximation theorem, the neural network can theoretically approximate to any continuous function, so that the neural network can learn any mapping. A conventional communication system needs to design a communication module with rich expert knowledge. However, a neural network-based deep learning communication system can automatically discover an implicit pattern structure from a large quantity of data sets, establish a mapping relationship between data, and obtain performance better than that of a conventional modeling method.

For example, a deep neural network (deep neural network, DNN) is a neural network with a large quantity of layers. Based on different network structures and usage scenarios, the DNN may include a feedforward neural network (feedforward neural network, FNN), a convolutional neural network (convolutional neural networks, CNN), a recursive neural network (recurrent neural network, RNN), and the like. A specific form of the DNN is not limited in this disclosure. The neural network described in this disclosure is, for example, a DNN, or may be a neural network of another type.

In this disclosure, unless otherwise specified, a quantity of nouns represents "a singular noun or plural nouns", that is, "one or more". "At least one" means one or more, and "a plurality of" means two or more. The term "and/or" describes an association relationship for describing associated objects and represents that three relationships may exist. For example, A and/or B may represent the following cases: Only A exists, both A and B exist, and only B exists, where A and B may be singular or plural. When representing a feature, the character "/" may indicate an "or" relationship between associated objects. For example, A/B indicates A or B. When representing an operation, the symbol "/" may further represent a division operation. In addition, in this disclosure, the symbol "x" may also be replaced with a symbol "*".

The ordinal numbers such as "first" and "second" in this disclosure are used to distinguish a plurality of obj ects, and are not used to limit sizes, content, sequences, time sequences, application scenarios, priorities, importance degrees, or the like of the plurality of objects. For example, a first model and a second model may be a same model, or may be different models. In addition, the names do not indicate different parameters, priorities, application scenarios, importance degrees, or the like of the two models.

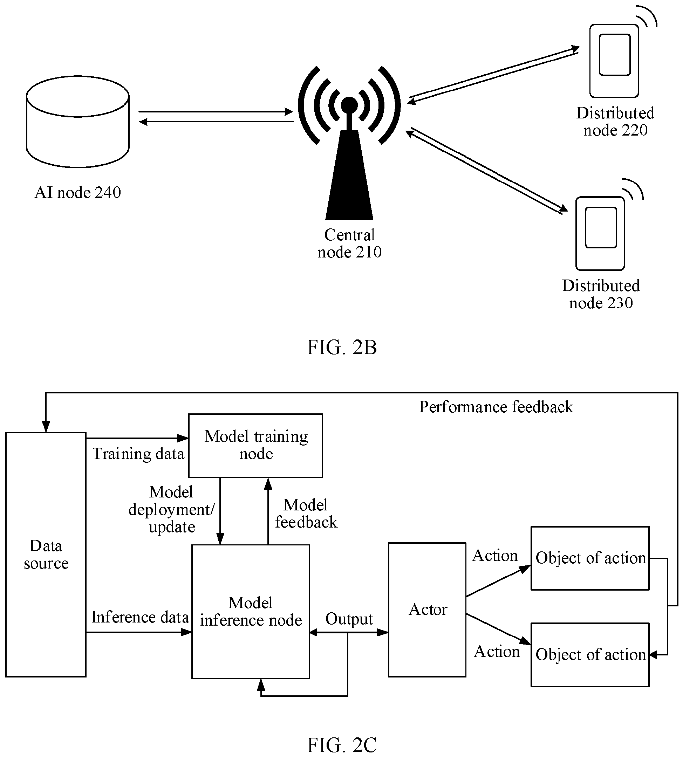

FIG. 2A and FIG. 2B show communication network architectures in the communication system 10 provided in this disclosure. Any method embodiment provided subsequently is applicable to the architectures. Refer to FIG. 2A. The communication network architecture includes a central node 210, a distributed node 220, and a distributed node 230. The distributed nodes 220 and 230 may access the central node 210 and communicate with the central node 210. The distributed nodes 220 and 230 may be terminal devices, and the central node 210 is an access network device. Alternatively, the distributed nodes 220 and 230 may be DUs, and the central node 210 is a CU. Alternatively, the distributed nodes 220 and 230 may be access network devices, and the central node 210 is a core network device. Alternatively, the distributed nodes 220 and 230 and the central node 210 may all be artificial intelligence (Artificial Intelligence, AI) network elements/function modules. In subsequent embodiments of this disclosure, an example in which the central node is an access network device and the distributed node is a terminal device is mainly used.

In addition, as shown in FIG. 2B, the network architecture may further include an AI node 240. The central node 210 may forward, to the AI node 240, AI model-related data that is reported by the distributed node 220 and/or 230. The AI node 240 performs an operation such as model update (model training), and forwards an updated model to the distributed node 220 and/or 230 by using the central node 210. An inference function corresponding to the model may be completed on the AI node 240. For example, the AI node 240 releases an inference result to at least one of the central node 210, the distributed node 220, or the distributed node 230. Alternatively, after the AI node releases the model to the central node 210, the central node 210 completes the inference function, and the central node may release the inference result to the distributed node 220 and/or the distributed node 230. The AI node 240 may be configured to manage an AI model. The AI node 240 is, for example, an independent AI node, or may be a function module. The function module may be disposed in an AI node, or may be disposed in another device. The another device is, for example, an access network device or a core network device. FIG. 2A and FIG. 2B are merely schematic diagrams. Quantities of various types of devices included in the communication system are not limited in this disclosure.

The machine learning technology in this disclosure is a specific implementation of the AI technology. For ease of understanding, the following describes the AI technology. It may be understood that the description is not intended to limit this disclosure.

AI is a technology that performs complex calculation by simulating the human brain. With the improvement of data storage and capabilities, AI is applied more widely.

FIG. 2C is a schematic diagram of an application framework of AI. A data source (data source) is configured to store training data and inference data. A model training node (model training host) analyzes or trains training data (training data) provided by the data source to obtain an AI model, and deploys the AI model on a model inference node (model inference host). The AI model represents a mapping relationship between an input and an output of the model. Obtaining an AI model through learning by the model training node is equivalent to obtaining the mapping relationship between the input and the output of the model through learning by the model training node by using training data. The model inference node uses the AI model to perform inference based on the inference data provided by the data source and obtain an inference result. The method may also be described as follows: The model inference node inputs the inference data to the AI model, and obtains an output by using the AI model. The output is the inference result. The inference result may indicate a configuration parameter used (acted) by an object of action, and/or an operation performed by the object of action. The inference result may be planned by an actor (actor) entity in a unified manner, and sent to one or more objects of action (for example, network entities) for action.

In this disclosure, an AI function may include at least one of the following: data collection (collecting training data and/or inference data), model learning, model information release (configuring model information), inference, or inference result release. In this disclosure, the AI model may be referred to as a model for short. In addition, model learning may also be understood as model training.

When the AI function is introduced into communication between the access network device and the terminal device, some data, for example, data such as a downlink received signal or downlink channel state information, can be obtained only on a terminal device (for example, (user equipment, UE)) side, and cannot be directly obtained by a network side (for example, obtained after being reported by the UE). Data collected by a single terminal device may be simple, and a large amount of real data that cannot be traversed is distributed. In addition, a single terminal device may obtain a small amount of data. If a single terminal device trains a corresponding AI model based on obtained data, it may be difficult to train an AI model with sufficient good performance. However, if a large quantity of terminal devices or all terminal devices in a cell send data to a base station, and the base station performs unified training by using the data, or the base station delivers the data to a node that can implement a model training function, such as an AI node or a core network device on a network side, for unified training, overheads of transmitting data by the terminal device to the base station are excessively high.

To implement low overheads, in this disclosure, federated learning is introduced into communication between the access network device and the terminal device, so that an accurate model can be obtained through training, to improve data transmission efficiency.

In this case, a federated learning manner can be used to train the AI model.

For example, a process of performing federated learning in the foregoing scenario is as follows:

1. Participants (for example, one or more terminal devices) separately download a current global model from a central node (for example, a base station, an AI node, a core network device, or operation, administration, and maintenance (operation, administration and maintenance, OAM)). Optionally, when the participant is a terminal device and the central node is not the base station, the base station may forward information about the global model from the central node to the terminal device. The participant may also be described as a distributed node.

2. Each participant uses local data to train a local model of the participant, and after training, local information is uploaded to the central node (for example, a current local model or a gradient of the current local model, where the gradient of the current local model is, for example, a gradient between the current local model and a global model received from the central node last time; alternatively, it may be understood that, for known local data, a loss function is considered as a function of all to-be-trained parameters in the AI model (if a quantity of all to-be-trained parameters is 1, the loss function is a unary function; or if a quantity of all to-be-trained parameters is greater than 1, the loss function is a multi-ary function); when values of all the to-be-trained parameters are values of corresponding to-be-trained parameters included in information about the global model received from the central node last time, the gradient of the loss function is the gradient of the current local model; and the information about the global model that is received from the central node last time may include values of all to-be-trained parameters). The central node aggregates local information of each participant to update parameters of the global model, to obtain an updated global model. Optionally, when the participant is a terminal device and the central node is not the base station, the base station may forward gradient information from the terminal device to the central node.

The foregoing two steps may be repeated until the global model is converged. The finally obtained global model is a target model obtained through training, and may be used for inference.

In the federated learning manner, the participant uploads the local information obtained through training to the central node, and does not need to upload a large amount of training data to the central node, so that transmission overheads can be reduced.

When the federated learning is applied to communication between an access network device and UE, a global model obtained through learning may be used to infer a parameter to be used by the access network device, an operation to be performed by the access network device, a parameter to be used by the terminal device, and/or an operation to be performed by the terminal device in the communication process. An inference process may be implemented by the access network device. Alternatively, an inference process may be implemented by another device, and an inference result is released to the access network device, the inference result is released to the terminal device, and/or the inference result is released to the terminal device by using the access network device.

In this disclosure, the global model may be denoted as a first-type model, and the local model may be denoted as a second-type model. Specific names of the global model and the local model are not limited in this disclosure. The global model may be trained and updated by the central node. The local model may be trained and updated by a participating node (distributed node).

In this disclosure, a node (for example, an access network device, a core network device, OAM, or an AI node) that implements a learning function of a global model may be the same as or different from a node (for example, an access network device, a core network device, OAM, or an AI node) that implements an inference function of the global model. The learning function of the model is, for example, model (update) training. The OAM may also be referred to as a network management system for short, and is configured to operate, manage, and/or maintain at least one of the core network device and the access network device. For example, a node that implements the learning function of the global model is the core network device or OAM, and a node that implements the inference function of the global model is an access network device; or a node that implements the learning function of the global model and a node that implements the inference function of the global model are both OAM; or a node that implements the learning function of the global model and a node that implements the inference function of the global model are both access network devices. Examples are not provided herein one by one. When a node that implements the learning function of the global model is different from a node that implements the inference function of the global model, the node that implements the learning function of the global model may release model information to the node that implements the inference function of the global model.

Optionally, in this disclosure, when a node that implements the learning function of the global model is the same as a node that implements the inference function of the global model, a module that implements the learning function of the global model and a module that implements the inference function of the global model may be a same module in the node, for example, an AI module (or an AI entity) in OAM, or an AI module (or an AI entity) in the access network device; or the module that implements the learning function of the global model and the module that implements the inference function of the comprehensive model may be different modules in the node. For example, an AI entity A in the access network device implements the learning function, and an AI entity B in the access network device implements the inference function. Examples are not provided herein one by one.

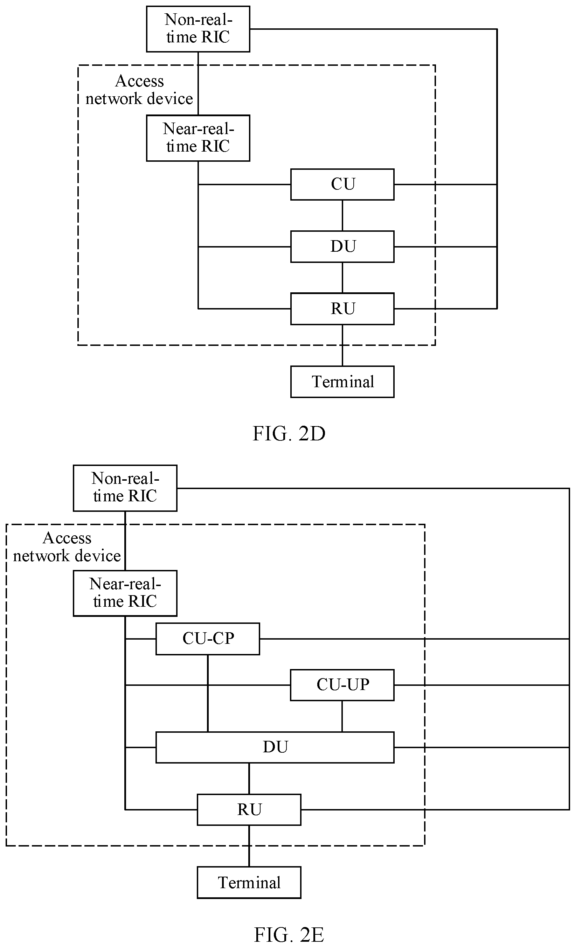

FIG. 2D is an example diagram of a network architecture to which a method according to this disclosure can be applied.

As shown in FIG. 2D, in a first possible implementation, an access network device includes a near-real-time radio access network intelligent control (RAN intelligent controller, RIC) module, configured to perform model learning and/or inference. For example, the near-real-time RIC may obtain information on a network side and/or a terminal side from at least one of a CU, a DU, and an RU, and the information may be used as training data or inference data. Optionally, the near-real-time RIC may submit an inference result to at least one of the CU, the DU, and the RU. Optionally, the CU and the DU may exchange the inference result. Optionally, the DU and the RU may exchange the inference result. For example, the near-real-time RIC submits the inference result to the DU, and the DU submits the inference result to the RU. For example, the near-real-time RIC is configured to train a global model and perform inference by using the global model.

As shown in FIG. 2D, in a second possible implementation, a non-real-time RIC may be located outside the access network device (optionally, the non-real-time RIC may be located in OAM or a core network device), and is configured to perform model learning and inference. For example, the non-real-time RIC may obtain information on the network side and/or the terminal side from at least one of the CU, the DU, and the RU. The information may be used as training data or inference data, and an inference result may be submitted to at least one of the CU, the DU, and the RU. Optionally, the CU and the DU may exchange the inference result. Optionally, the DU and the RU may exchange the inference result. For example, the non-real-time RIC submits the inference result to the DU, and the DU submits the inference result to the RU. For example, the non-real-time RIC is configured to train a global model and perform inference by using the global model.

As shown in FIG. 2D, in a third possible implementation, the access network device includes a near-real-time RIC, and a non-real-time RIC is located outside the access network device (optionally, the non-real-time RIC may be located in OAM or the core network device). Same as the second possible implementation, the non-real-time RIC may be configured to perform model learning and/or inference. Same as the first possible implementation, the near-real-time RIC may be configured to perform model learning and/or inference; and/or the near-real-time RIC may obtain AI model information from the non-real-time RIC, obtain information on the network side and/or the terminal side from at least one of the CU, the DU, and the RU, and obtain an inference result by using the information and the AI model information. Optionally, the near-real-time RIC may submit the inference result to at least one of the CU, the DU, and the RU. Optionally, the CU and the DU may exchange the inference result. Optionally, the DU and the RU may exchange the inference result. For example, the near-real-time RIC submits the inference result to the DU, and the DU submits the inference result to the RU. For example, the near-real-time RIC is configured to train a global model A and perform inference by using the global model A. For example, the non-real-time RIC is configured to train a global model B and perform inference by using the global model B. For example, the non-real-time RIC is configured to train a global model C, and submit the global model C to the near-real-time RIC, and the near-real-time RIC performs inference by using the global model C.

FIG. 2E is an example diagram of a network architecture to which a method according to this disclosure can be applied. Compared with FIG. 2D, in FIG. 2E, a CU is separated into a CU-CP and a CU-UP.

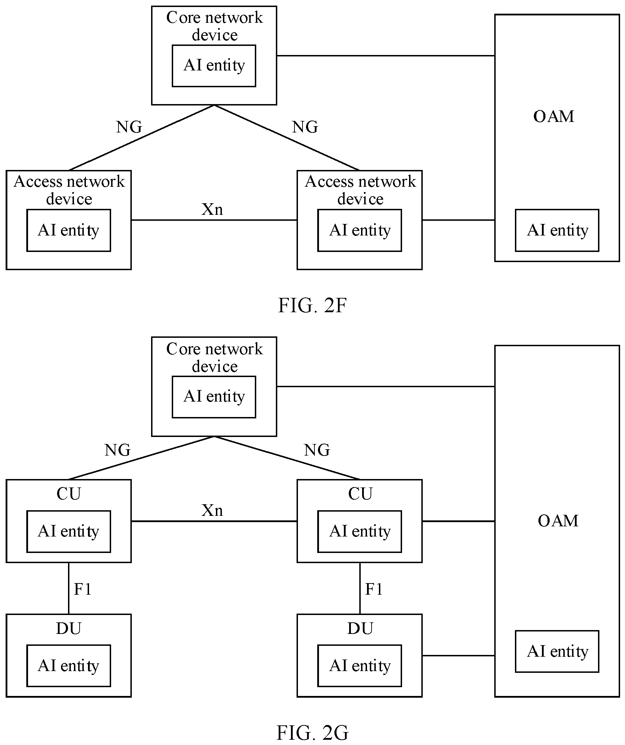

FIG. 2F is an example diagram of a network architecture to which a method according to this disclosure can be applied. As shown in FIG. 2F, optionally, an access network device includes one or more AI entities, and a function of the AI entity is similar to that of the near-real-time RIC. Optionally, OAM includes one or more AI entities, and a function of the AI entity is similar to that of the non-real-time RIC. Optionally, a core network device includes one or more AI entities, and a function of the AI entity is similar to that of the non-real-time RIC. When the OAM and the core network device each include an AI entity, models obtained by training by the AI entities of the OAM and the core network device are different, and/or models used for inference are different.

In this disclosure, that the models are different includes at least one of the following: structure parameters (for example, quantities of layers and/or weights of the models) of the models are different, input parameters of the models are different, or output parameters of the models are different.

FIG. 2G is an example diagram of a network architecture to which a method according to this disclosure can be applied. Compared with FIG. 2F, in FIG. 2G, an access network device is separated into a CU and a DU. Optionally, the CU may include an AI entity, and a function of the AI entity is similar to that of the near-real-time RIC. Optionally, the DU may include an AI entity, and a function of the AI entity is similar to that of the near-real-time RIC. When the CU and the DU each include an AI entity, models obtained by training by the AI entities of the CU and the DU are different, and/or models used for inference are different.

In this disclosure, one parameter or a plurality of parameters may be obtained through inference by using one model. Learning processes of different models may be deployed on different devices or nodes, or may be deployed on a same device or node. Inference processes of different models may be deployed on different devices or nodes, or may be deployed on a same device or node.

A learning process of a global model is deployed on a network side, for example, deployed on an access network device, an AI node independent of the access network device, a core network device, or OAM. When the learning process of the global model is deployed on another device that is not an access network device, UE may directly communicate with the another device. Alternatively, similar to the foregoing description, the UE communicates with the another device by using the access network device, that is, forwards information or data by using the access network device. This disclosure is described by using an example in which the learning process of the global model is deployed on the access network device. The access network device sends information about the global model to the UE, and the UE may train the global model based on local training data, to obtain a local model. Then, the UE sends information about the local model to the access network device, and the access network device obtains update information of the global model based on the information.

The following describes the method provided in this disclosure with reference to the accompanying drawings. Steps or operations included in these methods are merely examples, and other operations or variations of various operations may be further performed in this disclosure. In addition, the steps may be performed in a sequence different from a sequence presented this disclosure, and not all the operations in this disclosure may be performed. In these methods, the access network device may be considered as an example of a central node, and the UE may be considered as an example of a distributed node.

This disclosure provides a method to improve performance of a neural network model. In this disclosure, for example, first duration is used in one round of training process. If first information of a local model is received in the first duration, it indicates that the first information of the local model is available, and an access network device may use the first information of the local model, for example, update a global model based on the first information of the local model. If first information of some local models is received after the first duration expires, the first information of the local models may be considered as outdated information, and the access network device may not consider the first information of the local models when updating the global model. This can ensure that an update progress of local information matches an update progress of the global model, and improve accuracy and performance of the global model obtained by the access network device. The following describes the method by using some embodiments.

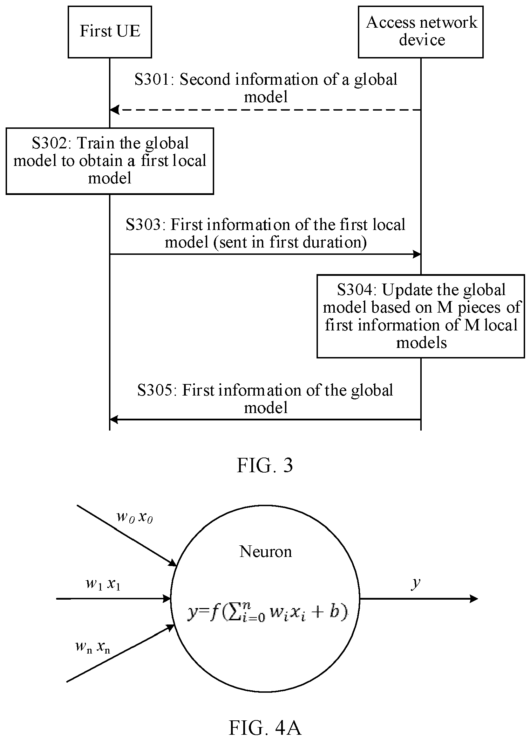

FIG. 3 is a flowchart of a first communication method according to this disclosure.

S301: An access network device sends second information of a global model. Correspondingly, first UE receives the second information of the global model.

For example, the access network device sends the second information of the global model in a broadcast or multicast manner, or the access network device may separately send the second information of the global model to K UEs in a unicast manner. A part or all of the K UEs receive the second information of the global model from the access network device. K is a positive integer. The first UE is included in the K UEs.

In the method, the access network device maintains a neural network model, and each UE performs distributed training on the model, and sends a training result (for example, information about a local model) to the access network device. The access network device updates the maintained model based on the training result. Therefore, a model maintained by the UE is referred to as a local model, and the model maintained by the access network device is referred to as a global model. However, actually, the UE does not maintain a model additionally, and the local model maintained by the UE is obtained by training the global model.

Optionally, initial information of the global model may be agreed on in a protocol, that is, the UE may obtain the information about the global model according to the protocol during initial training (the first round of training). Then (in the second round of training and subsequent training), each time the UE performs training, the UE obtains information about a current global model by using S301. Alternatively, when the UE performs initial training (the first round of training) and subsequent training (the second round of training and subsequent training), the UE obtains information about a current global model by using S301.

The second information of the global model is, for example, information before the global model is updated. The second information of the global model indicates neural network structure information and/or neural network parameter information of the global model. Optionally, information that is about the global model and that is not indicated by the second information may be agreed on according to a protocol. Optionally, the second information of the global model may be carried in one message, or may be carried in a plurality of messages. This is not limited. The neural network structure information indicates a neural network type used by the global model. The neural network structure information may describe a connection relationship between neurons in a neural network. For example, the neural network type may be an FNN, a CNN, an RNN, or the like, or an operation type of each layer included in the neural network. For example, an operation type of a layer of the neural network may be a full-connected operation, a convolution operation, a non-linear operation, a normalization operation, or an upsampling operation. Operation types of different layers may be the same or different. This is not limited. The neural network structure information may further indicate a quantity of layers of the neural network. The neural network structure information may directly indicate a type and/or a quantity of layers of the neural network, or may indicate one of at least one candidate item. Each candidate item indicates a type and/or a quantity of layers of one neural network. The at least one candidate item may be predefined (agreed on) in a protocol, or may be preconfigured by the access network device for the UE by using signaling. Because a structure of the neural network almost does not change during training, optionally, the neural network structure information may be sent only once before training, or may be sent only once in the first round of training, or certainly may be sent in a plurality of rounds of training or even in each round of training. This is not limited. The neural network parameter information indicates at least one of the following parameters of the neural network: a weight, an offset, an activation function, or the like. For example, the global model corresponds to a plurality of parameters, and the second information of the global model is, for example, information about all of the plurality of parameters corresponding to the global model, or information about a part of the plurality of parameters corresponding to the global model. If the second information of the global model is information about a part of parameters corresponding to the global model, optionally, the second information of the global model may further include an identifier of the second information of the global model, or include an identifier of a parameter corresponding to the second information of the global model, so that the terminal device can determine the parameter corresponding to the second information of the global model.

The idea of the neural network is from a neuron structure of brain tissue. For example, each neuron performs a weighted summation operation on an input value of the neuron, and outputs an operation result by using an activation function. FIG. 4A is a schematic diagram of a neuron structure. It is assumed that inputs of a neuron are $x = [x_0, x_1, \dots, x_n]$, and weights corresponding to the inputs are respectively $w = [w, w_1, \dots, w_n]$, where $w_i$ is a weight of $x_i$ and is used to weight $x_i$. An offset for performing weighted summation on the input values based on the weights is, for example, b. There may be a plurality of forms of the activation function. Assuming that an activation function of a neuron is $y = f(z)$ = max(0, z), an output of the neuron is $y = f\left(\sum_{i=0}^{i=n} w_i * x_i + b\right) = \max(0, \sum_{i=0}^{i=n} w_i * x_i + b)$. For another example, if an activation function of a neuron is $y = f(z) = z$, an output of the neuron is $y = f\left(\sum_{i=0}^{i=n} w_i * x_i + b\right) = \sum_{i=0}^{i=n} w_i * x_i + b$. b may be any possible value such as a decimal, an integer (for example, 0, a positive integer, or a negative integer), or a complex number. Activation functions of different neurons in the neural network may be the same or different.

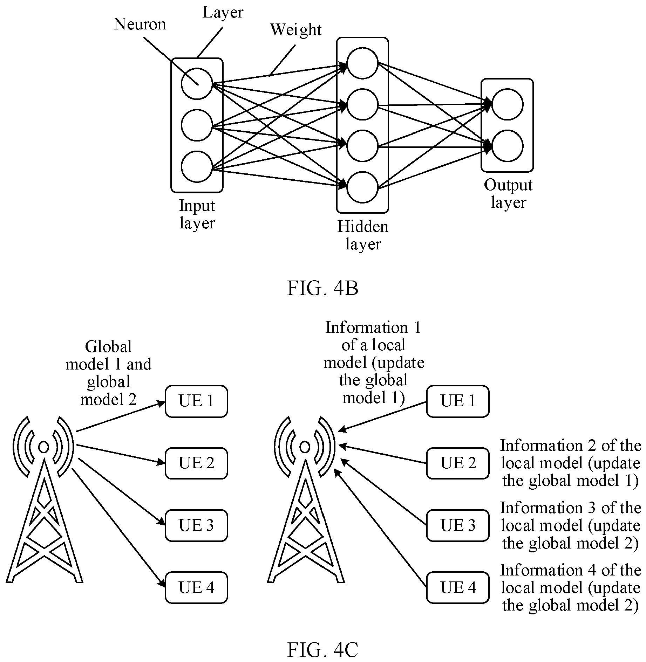

The neural network generally includes a plurality of layers, and each layer may include one or more neurons. By increasing a depth and/or a width of the neural network, an expression capability of the neural network can be improved, and a more powerful information extraction and abstraction modeling capability can be provided for a complex system. The depth of the neural network may be a quantity of layers included in the neural network, and a quantity of neurons included in each layer may be referred to as a width of the layer. In an implementation, the neural network includes an input layer and an output layer. The input layer of the neural network performs neuron processing on received input information, and transfers a processing result to the output layer, and the output layer obtains an output result of the neural network. In another implementation, the neural network includes an input layer, a hidden layer, and an output layer. Refer to FIG. 4B. The input layer of the neural network performs neuron processing on received input information, and transfers a processing result to an intermediate hidden layer. The hidden layer performs calculation on the received processing result to obtain a calculation result. The hidden layer transfers the calculation result to the output layer or an adjacent hidden layer. Finally, the output layer obtains an output result of the neural network. One neural network may include one hidden layer, or include a plurality of hidden layers that are sequentially connected. This is not limited.

In addition, in a training process of the neural network, a loss function may be defined. The loss function describes a difference or a difference value between an output value of the neural network and an ideal target value, and this disclosure does not limit a specific form of the loss function. A training process of the neural network is a process in which a parameter of the neural network is adjusted, so that a value of the loss function is less than a threshold, or a value of the loss function meets a target requirement. A parameter of the neural network is adjusted. For example, at least one of the following parameters is adjusted: a quantity of layers of the neural network, a width of the neural network, a weight of a neuron, or a parameter in an activation function of a neuron.

A global model may be trained once (one set of training may be performed) or for a plurality of times (a plurality of sets of training may be performed). A plurality of training processes may be performed discontinuously in time, or at least two training processes are performed continuously. This is not limited. For example, training is performed at intervals of a period of time. For example, the period of time is one hour, one day, one week, or one month. The period may be agreed on, or may be configured by the access network device. For another example, the access network device may aperiodically trigger training. One time of training may include a plurality of rounds of iterative training processes. For one time of training, for example, when S301 is performed at the start of training, S301 may be performed in the first round of training process, the global model is a model maintained by the access network device, and the global model is not trained and updated in this training; or S301 may be performed in a training process, for example, in a round of training process, the round of training process is not the first round of training process, and the global model may be trained in one or more rounds of training. Training data used to train the global model is data that can be obtained by UE. The access network device sends the second information of the global model to the UE. Each UE separately performs training, and sends a training result to the access network device after training. The access network device updates the global model based on the training result.

The K UEs are, for example, a part or all UEs covered by the access network device. For example, the access network device maintains a global model, and the global model is applicable to a plurality of UEs covered by the access network device. Alternatively, in some scenarios, distribution of local data (for example, training data used to train the global model) of different UEs varies greatly. When these UEs train a model in a distributed manner, it may be difficult for the model to converge. In this case, the UEs may be grouped. UEs whose local data is distributed similarly or UEs with similar environments of channels to the access network device are grouped into one group, and one global model is trained for each group of UEs. In this case, the access network device may maintain a plurality of global models, and different global models correspond to different UE groups. For example, the K UEs are a part or all of UEs in one group.

In a possible implementation, grouping of the UEs may be completed by the access network device. Optionally, grouping information of the UEs may be indicated by the access network device to the UEs. For example, an identifier of a UE group including UE and/or UEs in the UE group including the UE may be indicated to the UE by the access network device. For example, when sending the information about the global model to the UEs, the access network device may separately send, to each group in a multicast manner, information about a global model corresponding to the group.

For example, if the access network device configures a different downlink resource for each group, the access network device sends, to the group on a downlink resource allocated to the group, information about the global model corresponding to the group. UE in a group also needs to receive information about a global model only on a downlink resource corresponding to the group, and the received information about the global model is information about the global model corresponding to the group.

For example, the access network device may configure different group numbers for different groups. When sending the information about the global model, the access network device may carry a group number (identifier) of the group corresponding to the global model. If UE receives information about a plurality of global models, the UE can determine information about a global model corresponding to the UE based on a group number of a group including the UE. The UE only needs to train the global model to obtain information about a local model.

For example, when sending information about the local model to the access network device, the UE may also carry the group number (an identifier, an index) of the group including the UE. According to the method, the access network device can identify the global model corresponding to the information about the local model.

For example, the access network device may also configure different uplink resources for different groups. According to the method, local models of different groups can be distinguished. For example, the UE sends, to the access network device on an uplink resource allocated to the group including the UE, the information about the local model corresponding to the group. The access network device may receive, on the uplink resource corresponding to the group, the information about the local model, and the received information about the local model is the information about the local model corresponding to the group.

In a possible implementation, grouping of UEs may also be completed by the UEs. For example, the access network device may send a plurality of global models. Refer to FIG. 4C. The access network device sends a global model 1 and a global model 2, and UE 1 to UE 4 all can receive the global model 1 and the global model 2. For example, if the access network device sends second information of the plurality of global models in S301, the UE may select a global model applicable to the UE from the second information.

For example, the UE may determine the global model corresponding to the UE based on a value of a fourth parameter, or it is considered that the UE may determine, based on the value of the fourth parameter, the group including the UE, to determine the global model corresponding to the group.

Optionally, values of fourth parameters may be divided into a plurality of value ranges, and it is considered that UEs whose values of the fourth parameter fall within a same range belong to one group. One value range corresponds to one global model. Global models corresponding to different value ranges may be a same model or may be different models. For example, if the value of the fourth parameter of the UE falls within a first range, it is determined that the UE corresponds to a global model corresponding to the first range. A correspondence between the value range of the fourth parameter and the global model may be predetermined in a protocol, or may be preconfigured by the access network device for the UE by using signaling. This is not limited.

Optionally, a plurality of reference values may be set. There is a difference between the fourth parameter of the UE and each reference value. If a difference between the fourth parameter of the UE and a reference value is less than a difference between the fourth parameter of the UE and another reference value, the reference value is considered as a target reference value of the UE. It is considered that UEs with a same target reference value belong to a same group. One reference value corresponds to one global model. Global models corresponding to different reference values may be a same model or may be different models. If a difference between the value of the fourth parameter of the UE and a reference value is the smallest, the UE corresponds to a global model corresponding to the reference value. For example, a first value is a reference value. If a difference between the value of the fourth parameter of the UE and the first value is less than a difference between the value and another reference value, it is determined that the UE corresponds to a global model corresponding to the first value. A correspondence between the reference value and the global model may be predetermined in a protocol, or may be preconfigured by the access network device for the UE by using signaling. This is not limited.

For example, the fourth parameter is reference signal received power (reference signal received power, RSRP), reference signal received quality (reference signal received quality, RSRQ), or root mean square (root mean square, RMS) delay spread. The value of the fourth parameter of the UE is, for example, a value obtained by the UE through measurement. For example, if the fourth parameter is RMS delay spread, the UE may determine the global model corresponding to the UE based on the RMS delay spread obtained through measurement.

For example, the access network device may send a classification network to each UE in a broadcast, multicast, or unicast manner. The classification network may classify parameters or measurement amounts of the UEs. An input of the classification network includes the parameters or the measurement amounts of the UEs, and an output of the classification network includes a class identifier or is used to determine the class identifier. The parameters or the measurement amounts may be optionally used as training data of local models of the UEs. It is considered that UEs whose parameters or measurement amounts belong to a same class belong to one group. One class corresponds to one global model, and global models corresponding to different classes may be a same model or different models. The UE may determine, according to the classification network, a class to which a parameter or a measurement amount of the UE belongs, to determine that the UE uses a global model corresponding to the class. A correspondence between the class (identifier) and the global model may be predetermined in a protocol, or may be preconfigured by the access network device for the UE by using signaling. This is not limited. The input of the classification network includes, for example, a fifth parameter. The fifth parameter and the fourth parameter may be a same parameter, for example, both are RSRP. Alternatively, the fifth parameter and the fourth parameter may be different parameters. For example, the fourth parameter is RMS delay spread, and the fifth parameter is RSRP.

For example, the UE may test a plurality of global models from the access network device by using local training data, and select a global model based on a test result. For example, a global model with a best test result is selected. For example, the UE tests the plurality of global models, and obtains a plurality of test results. For example, a test result is a value of a loss function, and a global model corresponding to a test result with a smallest value (or a lowest value) in the plurality of test results is considered as the global model with the best test result.

Optionally, if the UE determines grouping information or determines the global model from the plurality of global models, the UE may report the grouping information of the UE to the access network device. For example, UE may report an identifier (index) of a UE group including the UE to the access network device; or the UE may report an identifier (index) of a selected global model to the access network device. For example, UE may report an identifier of a global model selected by the UE to the access network device. For example, the information about the local model sent by the UE to the access network device may carry a group number of the UE, or carry the index of the global model used by the UE. During processing, the access network device updates a corresponding global model based on information about a local model with a same group number (or a same index), so that the access network device does not use the information about the local model in update of an inapplicable global model. Still refer to FIG. 4C. For example, the UE 1 and the UE 2 are applicable to the global model 1, and the UE 3 and the UE 4 are applicable to the global model 2. In this case, the access network device may update the global model 1 based on information about a local model from the UE 1 and information about a local model from the UE 2, and update the global model 2 based on information about a local model from the UE 3 and information about a local model from the UE 4.

The information that is about the global model and that is sent by the access network device is, for example, information at a physical layer. For example, a manner of generating the information about the global model (that is, a processing process at a transmit end) is defined at the physical layer. The generation manner includes one or more of a quantization manner of a model parameter, a sequence of forming a bit sequence, a coding scheme, or a format of a transmission block (transmission block, TB). The access network device may send the information about the global model by using physical layer signaling. For example, one type of physical layer signaling is downlink control information (downlink control information, DCI).

Alternatively, the information that is about the global model and that is sent by the access network device may be information at a media access control (medium access control, MAC) layer. For example, a MAC control element (control element, CE) used to carry the information about the global model is defined, and the access network device may send the information about the global model by using such a MAC CE.

Alternatively, the information that is about the global model and that is sent by the access network device may be information at a radio resource control (radio resource control, RRC) layer. For example, an RRC information element (information element, IE) used to carry the information about the global model is defined, and the access network device may send the information about the global model by using RRC signaling including such an IE.

Alternatively, the information that is about the global model and that is sent by the access network device may be information at a higher layer, for example, information at an application layer. The access network device may send the information about the global model by using signaling of the application layer. From the perspective of a bottom layer of the application layer, the information about the global model is some data packets transmitted from an upper layer.

For example, the access network device may preconfigure a periodic downlink resource for the UE by using signaling. For example, the access network device may need to send the information about the global model to a plurality of UEs. The access network device uniformly preconfigures periodic downlink resources for the plurality of UEs, or may separately preconfigure periodic downlink resources for different UEs. For example, a periodic downlink resource configured by the access network device for the first UE is referred to as a first downlink resource, and the access network device may send the information about the global model to the first UE by using the first downlink resource. In addition, if the access network device configures the periodic downlink resource, the access network device may send configuration information to the UE, to indicate the periodic downlink resource. For example, if the access network device configures the first downlink resource for the first UE, the access network device may send second configuration information to the first UE. The second configuration information may be used to configure the first downlink resource. Alternatively, if the access network device configures the first downlink resource for a plurality of UEs, the access network device may broadcast or multicast the second configuration information. The second configuration information may be used to configure the first downlink resource.

Alternatively, the periodic downlink resource may be predefined by a protocol. The periodic downlink resource may be used to send the information about the global model. The periodic downlink resource includes, for example, a downlink control channel resource and/or a downlink data channel resource. For example, the downlink control channel resource is a physical downlink control channel (physical downlink control channel, PDCCH) resource. The downlink data channel resource is, for example, a physical downlink shared channel (physical downlink shared channel, PDSCH) resource. For example, the periodic downlink resource includes periodic PDCCH monitoring opportunities, and the access network device may send the information about the global model on the periodic PDCCH monitoring opportunities, or the access network device may schedule a PDSCH by sending scheduling information on a part or all of the PDCCH monitoring opportunities. The PDSCH may carry the information about the global model. For another example, a downlink resource used to send the information about the global model includes periodic PDSCHs, and the access network device sends the information about the global model by using the periodic PDSCHs.

Optionally, in this disclosure, preconfiguration by the access network device may be further described as follows: The access network device performs preconfiguration for the UE by using signaling (for example, system information, a broadcast message, RRC signaling, a MAC CE, or downlink control information (downlink control information, DCI)).

Optionally, if a downlink resource is periodic, configuration information of the periodic downlink resource includes, for example, one or more of the following: a time domain start position, a periodicity, a frequency domain start position, a frequency domain bandwidth, a modulation and coding scheme (modulation and coding scheme, MCS), or a repeat transmission configuration.

Optionally, one global model may correspond to a plurality of parameters. Some parameters may be changed quickly or may be updated quickly, and some parameters may be updated slowly. Optionally, parameters of the global model may be divided into at least two parameter groups through protocol predefinition or configuration by the access network device, and each parameter group includes one or more parameters. For example, the second information of the global model may include information about a part or all of the parameter groups of the global model. Optionally, the access network device may preconfigure a plurality of periodic downlink resources, or a plurality of periodic downlink resources may be predefined in a protocol, and one periodic downlink resource corresponds to one or more parameter groups. The periodic downlink resource herein is a downlink resource reserved according to a periodicity. For example, for some parameter groups that do not need to be frequently updated, or parameter groups that change slowly, a long periodicity of a periodic downlink resource may be preconfigured (or predefined) for such a parameter group, to reduce a quantity of times of delivering such a parameter group, and reduce signaling overheads. For a parameter group that needs to be frequently updated, or a parameter group that changes quickly, a short periodicity of a periodic downlink resource may be preconfigured (or predefined) for such a parameter group, to ensure an update frequency of a parameter included in such a parameter group.

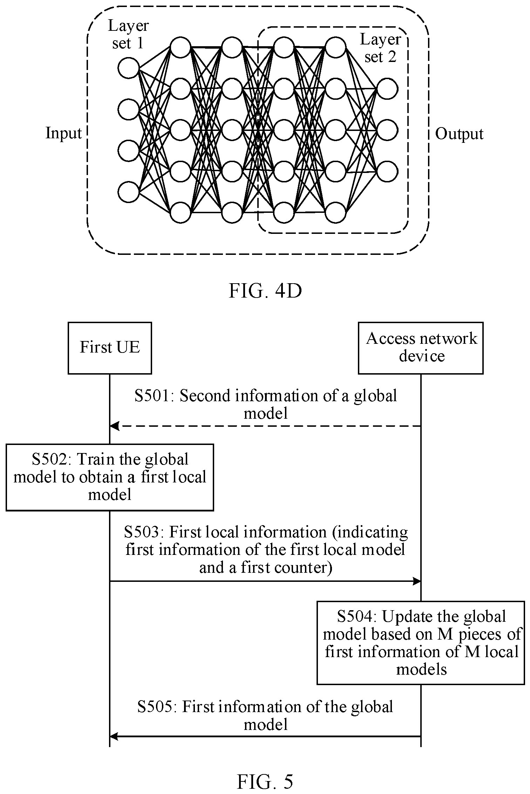

One global model may include a plurality of layers, and the layer herein is a neural network layer. When a neural network model (for example, the global model) is trained, parameters of some neural network layers of the global model may change quickly, and parameters of other neural network layers of the global model may change slowly. In this case, optionally, in the method of this disclosure, layers of the global model may be divided into a plurality of layer sets through predefinition or configuration by the access network device, and one layer set includes one or more layers. Different layer sets may have an intersection or have no intersection. Refer to an example in FIG. 4D. In FIG. 4D, there are five layers in the global model. The five layers may be divided into two layer sets. A layer set 1 is defined as {layer 1, layer 2, layer 3, layer 4, layer 5}, and a layer set 2 is defined as {layer 4, layer 5}. This is an example in which there is an intersection between layer sets. Alternatively, the set 1 may be defined as {layer 1, layer 2, layer 3}, and the layer set 2 is {layer 4, layer 5}. This is an example in which there is no intersection between the layer sets. The local model is obtained through training based on the global model. Therefore, a quantity of layers of the global model may be the same as a quantity of layers of the local model. In this case, the layers of the global model one-to-one correspond to the layers of the local model. Optionally, one parameter group may include all parameters corresponding to a part of layers of the global model, for example, include all parameters corresponding to a layer set of the global model. Alternatively, one parameter group may include a part of parameters corresponding to a part of layers of the global model, where for one of the part of layers, all or a part of parameters corresponding to the layer are included in the parameter group, but only a part of parameters corresponding to at least one of the part of layers are included in the parameter group. Alternatively, one parameter group may include a part of parameters corresponding to all layers of the global model, where for one of all the layers, all or a part of parameters corresponding to the layer are included in the parameter group, but only a part of parameters corresponding to at least one of all the layers are included in the parameter group.

For example, if a layer set of the global model includes three layers, and each layer corresponds to 10 to-be-trained or to-be-released parameters, all parameters of the layer set include 3x10=30 parameters. All parameters of the layer set are the 30 parameters, a part of parameters of the layer set are a proper subset of the 30 parameters, and a part of parameters of the layer set may correspond to any one or more of the three layers. For example, a part of parameters of the layer set are six parameters corresponding to the first layer of the three layers. Alternatively, a part of parameters of the layer set are three parameters corresponding to the first layer of the three layers and six parameters corresponding to the second layer of the three layers, that is, nine parameters in total. Alternatively, a part of parameters of the layer set are six parameters corresponding to the first layer of the three layers, six parameters corresponding to the second layer, and six parameters corresponding to the third layer, that is, 18 parameters in total.

For another example, if one layer of the global model corresponds to 10 to-be-trained or to-be-released parameters, the 10 parameters are all parameters of the layer, and a part of parameters of the layer are a proper subset of the 10 parameters.

For another example, if the global model includes three layers in total, a part of layers of the global model are any one or two of the three layers. For example, each of the three layers corresponds to 10 to-be-trained or to-be-released parameters. If a part of layers of the global model are one of the layers, all parameters of the part of layers of the global model are 10 parameters corresponding to the layer, and a part of parameters of the part of layers of the global model are a proper subset of the 10 parameters corresponding to the layer. Alternatively, if a part of layers of the global model are two of the layers, all parameters of the part of layers of the global model are 20 parameters corresponding to the two layers, and a part of parameters of the part of layers of the global model are a proper subset of the 20 parameters corresponding to the two layers.

For another example, if the global model includes three layers in total, all the layers of the global model are the three layers. For example, if each of the three layers corresponds to 10 to-be-trained or to-be-released parameters, all parameters of all layers of the global model are 30 parameters corresponding to the three layers, and a part of parameters of all layers of the global model are a proper subset of the 30 parameters corresponding to the three layers. All parameters corresponding to all layers of the global model are also understood as all parameters of the global model, and a part of parameters corresponding to all layers of the global model are also understood as a part of parameters of the global model.

In addition, as described above, if the second information of the global model is information about a part of parameters corresponding to the global model, optionally, the second information of the global model may further include an identifier of the second information of the global model, or include an identifier of a parameter corresponding to the second information of the global model. In an implementation, for example, if the second information of the global model is information about parameters corresponding to a part of layer sets of the global model, the second information of the global model may include identifiers of these layer sets, and the identifiers of these layer sets may be used as identifiers of the second information of the global model.

In the following description, if there are concepts such as a part of parameters or all parameters of a local model, an understanding manner is similar to an understanding manner of a parameter of the global model, and details are not described.

Alternatively, the downlink resource used to send the information about the global model may be aperiodic. For example, the access network device preconfigures a downlink control channel resource or a protocol predefines a downlink control channel resource. The access network device schedules, on the preconfigured downlink control channel resource based on an update status of the global model, a downlink resource used to send the information about the global model, and the downlink resource used to send the information about the global model may be aperiodic. The aperiodic downlink resource used to send the information about the global model includes, for example, a downlink data channel resource and/or a downlink control channel resource. For example, the access network device sends second scheduling information to the first UE on the preconfigured downlink control channel resource. The second scheduling information may be used to schedule the first downlink resource, and the first downlink resource is, for example, a PDSCH resource and/or a PDCCH resource. After receiving the second scheduling information, the first UE may perform detection on the first downlink resource, to receive the second information of the global model. This manner is flexible. When the information about the global model needs to be sent, the access network device may schedule a downlink resource used to send the information about the global model, and when the information about the global model does not need to be sent, the access network device may not need to schedule the resource, to save transmission resources and improve resource utilization.

In addition, as described above, if the second information of the global model is information about a part of parameters corresponding to the global model, optionally, the second information of the global model may further include an identifier of the second information of the global model, or include an identifier of a parameter corresponding to the second information of the global model. In addition, the identifier of the second information of the global model, the identifier of the parameter corresponding to the second information of the global model, or the like may not be included in the second information of the global model, but may be included in the scheduling information used to schedule the downlink resource, for example, included in the second scheduling information described in the previous paragraph.

The information about the global model sent by the access network device indicates, for example, a current global model, or indicates current parameter information of the global model. For example, parameter information indicated by the second information of the global model may include all parameter information of the global model, or include a part of parameter information of the global model. For example, the parameter information indicated by the second information of the global model includes a part of parameter information of the global model. In a possibility, the parameter information indicated by the second information of the global model includes a part of parameter groups of the global model. A parameter of the global model includes, for example, a parameter such as a weight of the global model. For example, the parameter information indicated by the second information of the global model is represented as a parameter set $\Phi = \{\Phi_1, \Phi_2, ... , \Phi_H\}$, where $\Phi_j$ represents the $j^{\text{th}}$ parameter of the global model, a value of j ranges from 1 to H, and H is a positive integer. For example, the parameter set includes H parameters in total, and H is a positive integer. UE may obtain a local model of the UE through training based on the parameter set $\Phi$. Optionally, if the parameter set $\Phi$ includes a part of parameters of the global model, a parameter that is not included in the parameter set $\Phi$ may remain unchanged in the training process. In other words, each time the UE receives the information about the global model, the UE may perform local model training only on a parameter corresponding to the information about the global model. For example, a parameter that is not indicated by the second information of the global model may remain unchanged in the training process. Alternatively, the access network device may send an identifier of a parameter group to the UE, to indicate, to the UE, a parameter that needs to be trained in this round. When sending the information about the local model, the UE may send only a trained parameter or a gradient set, to reduce complexity of local model training and air interface overheads reported by the local model.

Alternatively, the information that is about the global model and that is sent by the access network device may indicate a set of differences between a current global model and a previous global model, or indicate a gradient set of a current parameter of the global model (a parameter of the updated global model) and a previous corresponding parameter of the global model (a parameter of the global model before the update), or indicate a gradient set of a current parameter of the global model and a corresponding parameter that is of the global model and that is sent by the access network device to the UE last time or a corresponding parameter of an initial global model. For example, the second information of the global model may indicate a difference between second parameter information and third parameter information of the global model. The second parameter information is parameter information obtained by the access network device by updating the global model this time, and the third parameter information is parameter information that is of the global model and that is sent by the access network device to the UE last time or initially predefined parameter information of the global model. The "parameter information" in this disclosure may be understood as information about a parameter, for example, include a value of the parameter or an index corresponding to the value of the parameter. For example, the second parameter information may include information such as a value of a parameter indicated by the second information of the global model. The access network device and the UE may obtain a final global model of one training process after the training process. One training process includes a plurality of rounds of training processes. In each round of training process, the UE can obtain one local model, and the access network device can also obtain one global model. That the access network device updates the global model in this round means that the access network device updates the global model in this round of training. It may be understood that, in one round of training process, the access network device may update the global model once. A set of differences between a current parameter of the global model and a previous corresponding parameter of the global model is, for example, a gradient set of parameters of the global model, and is represented as a gradient set $\Delta\Phi = \{\Delta\Phi_1, \Delta\Phi_2, ... , \Delta\Phi_H\}$. For one UE, current second information of the global model may be determined by using second information that is of the global model and that is received last time and the gradient set $\Delta\Phi$. For example, the current second information of the global model determined by the UE is represented as $\Phi_j^t = \Phi_j^{t-1} + \eta * \Delta\Phi_j$ , $j \in \{1,2, ..., H\}$. $\eta$ is a learning rate, and a value is not equal to 0. For example, a value of $\eta$ is usually small, for example, $\eta$ is equal to 0.001, or may be another value. This is not limited. According to the method, the UE can obtain the local model of the UE through training based on the current second information of the global model. If the gradient set $\Delta\Phi$ includes a part of parameters of the global model, a parameter that is not included in the gradient set $\Delta\Phi$ may remain unchanged in the training process.

If S301 is the first time that the access network device sends the information about the global model, that is, S301 is the first round of training process in one training process, and there is no previous global model in this case, the second information of the global model may indicate current parameter information of the global model.

S301 is an optional step, and is represented by a dashed line in FIG. 3.

S302: The first UE trains the global model to obtain a first local model.

The first UE may obtain the first local model, for example, obtain first information of the first local model. Optionally, the first information of the first local model, for example, corresponds to the second information of the global model. For example, a parameter corresponding to (or indicating) the second information of the global model is the same as a parameter corresponding to (or indicating) the first information of the first local model. "Same" herein means that for example, a total quantity of parameters corresponding to the global model is the same as a total quantity of parameters corresponding to the first information of the first local model, and a parameter type corresponding to the global model is the same as a parameter type corresponding to the first information of the first local model. However, a value of a parameter corresponding to the global model may be the same as or different from a value of the parameter corresponding to the first information of the first local model. This is not limited. Alternatively, the parameter corresponding to the second information of the global model may be different from the parameter corresponding to the first information of the first local model. "Different" herein means that, for example, the total quantity of parameters corresponding to the global model is different from the total quantity of parameters corresponding to the first information of the first local model, and/or the parameter type corresponding to the global model is different from or not completely the same as the parameter type corresponding to the first information of the first local model.

The first UE is, for example, one of the K UEs. Because processing manners of the UEs after the UEs receive the second information of the global model are similar, the first UE is used as an example for description in this disclosure.

If the access network device sends second information of only one global model, the first UE may train the global model; or if the access network device sends second information of a plurality of global models, the first UE may determine a corresponding global model in the manner described above, to train the global model. For example, the first UE trains the global model based on training data obtained by the first UE, and a model obtained through training is referred to as the first local model.

The information about the first local model obtained by the first UE indicates, for example, the current first local model, or indicates current parameter information of the first local model. For example, parameter information indicated by the first information of the first local model may include all parameter information of the first local model, or include a part of parameter information of the first local model. If the first information of the first local model indicates a part of parameter information of the first local model, optionally, the first information of the first local model may further include an identifier of the first information of the first local model, or include an identifier of a parameter corresponding to the first information of the first local model, so that the access network device can determine the parameter corresponding to the first information of the first local model. For example, if the first information of the first local model includes parameters corresponding to a part of layer sets of the first local model, the first information of the first local model may include identifiers of these layer sets, and the identifiers of these layer sets may be used as identifiers of the first information of the first local model. Alternatively, if the first information of the first local model corresponds to the second information of the global model, for example, if a parameter corresponding to the second information of the global model is the same as a parameter corresponding to the first information of the first local model, the UE may not indicate the identifier of the first information of the first local model. For example, the first information of the first local model may not include the identifier of the first information of the first local model.

For example, the parameter information indicated by the first information of the first local model includes a part of parameter information of the first local model. In a possibility, the parameter information indicated by the first information of the first local model includes a part of parameter groups of the first local model. Optionally, the parameter indicated by the second information of the global model may be the same as the parameter indicated by the first information of the first local model. For example, the parameter information indicated by the first information of the first local model may be represented as a parameter set $\theta_e = \{\theta_{e,1}, \theta_{e,2}, \dots, \theta_{e,G}\}$. For example, the parameter indicated by the second information of the global model is the same as the parameter indicated by the first information of the first local model. Therefore, the parameter information indicated by the second information of the global model may also be represented by a parameter set in a same form. e indicates that the first local model is the $e^{th}$ local model received by the access network device. In other words, e indicates an index (index) of the local model, or indicates an index of the UE. A value of e is 1, 2, ..., or M. G represents a total quantity of parameters included in the parameter set $\theta_e$, and G is a positive integer. For example, G=H, or G and H may not be equal. $\theta_{e,i}$ represents the $i^{th}$ parameter of the first local model. Total quantities of parameters indicated by first information that is of local models and that is sent by different UEs in M UEs may be the same, for example, are all G, or may be different. For example, a total quantity of parameters indicated by first information that is of a local model and that is sent by second UE in the M UEs may be greater than G or less than G. In addition, parameter types indicated by first information that is of local models and that is sent by different UEs in the M UEs may also be the same, not completely the same, or completely different.

Alternatively, the information about the first local model obtained by the first UE may indicate a set of differences between the current first local model and the global model used for training the local model, or indicate a gradient set of a current parameter of the first local model and a corresponding parameter of the global model used for training the first local model. For example, the first information of the first local model may indicate a difference between the parameter information of the first local model and first parameter information. The first parameter information is parameter information of a global model that is sent by the access network device to the UE last time or a predefined initial global model, or the first parameter information is parameter information of an initial global model that is received by the first UE from the access network device last time or a predefined initial global model. In the foregoing two cases, the first parameter information and the third parameter information is, for example, same parameter information; or the first parameter information is parameter information that is of the first local model and that is sent by the first UE to the access network device last time. The gradient set indicated by the first information of the first local model is represented as, for example, $\Delta\theta_e = \{\Delta\theta_{e,1}, \Delta\theta_{e,2}, \dots, \Delta\theta_{e,G}\}$. For explanations of e and G, refer to the foregoing description. For example, $\Delta\theta_{e,i}$ represents a difference between a current value of the $i^{th}$ parameter of the first local model and a value of the $i^{th}$ parameter of the global model that is sent by the access network device to the UE last time or a value of the $i^{th}$ parameter of the predefined initial global model, or $\Delta\theta_{e,i}$ may represent the $i^{th}$ element included in a gradient of a loss function when a value of a to-be-trained parameter of the global model is a value of a to-be-trained parameter included in information about the global model that is sent by the access network device to the UE last time. The loss function is, for example, a multi-ary function, and each "element" (or each unknown number) corresponds to one to-be-trained parameter of the global model. The gradient of the loss function may be understood as a vector. The vector includes a plurality of elements. A quantity of the plurality of elements is equal to a quantity of variables (or unknown numbers) of the loss function, and is also equal to a quantity of to-be-trained parameters corresponding to the loss function. The $i^{th}$ element included in the gradient of the loss function is a gradient of the $i^{th}$ to-be-trained parameter corresponding to the loss function. The $i^{th}$ parameter of the first local model and the $i^{th}$ parameter of the global model are a same parameter.

S303: The first UE sends the first information of the first local model to the access network device in first duration. Correspondingly, the access network device receives the first information of the first local model, and the first information of the first local model may be received in the first duration.

For description of the first information of the local model, refer to the foregoing description.

For example, in the first duration, M UEs send first information of a local model to the access network device, and the access network device may receive a total of M pieces of first information. The M pieces of first information one-to-one correspond to M local models. For ease of description, the M pieces of first information of the M local models may also be described as the first information of the M local models, and the M pieces of first information of the M local models have a same meaning as the first information of the M local models. A sending process of each UE is similar. Therefore, the first UE is used as an example for description herein.

M is a positive integer. The M UEs are, for example, the same as the K UEs, or the M UEs are a subset of the K UEs, or the K UEs are a subset of the M UEs, or the M UEs and the K UEs have an intersection, or the M UEs and the K UEs may have no intersection. In this disclosure, an example in which the M UEs and the K UEs have an intersection (the first UE is UE included in the intersection) is used.

The information that is about the first local model and that is sent by the first UE is, for example, information at a physical layer. For example, a manner of generating information about a local model (that is, a processing process at a transmit end) is defined at the physical layer. The generation manner includes one or more of a quantization manner of a model parameter, a sequence of forming a bit sequence, a coding scheme, or a format of a transmission block. The first UE may send the information about the first local model by using physical layer signaling.

Alternatively, the information that is about the first local model and that is sent by the first UE may be information at a MAC layer. For example, a MAC CE used to carry information about a local model is defined, and the first UE may send the information about the first local model by using such a MAC CE.

Alternatively, the information that is about the first local model and that is sent by the first UE may be information at an RRC layer. For example, an RRC IE used to carry information about a local model is defined, and the first UE may send the information about the first local model by using RRC signaling including such an IE.

Alternatively, the information that is about the first local model and that is sent by the first UE may be information at a higher layer, for example, information at an application layer. The first UE may send the information about the first local model by using signaling of the application layer. From the perspective of a bottom layer of the application layer, the information about the first local model is some data packets transferred from an upper layer.

The information that is about the local model and that is sent by the UE and the information that is about the global model and that is sent by the access network device may be information at a same protocol layer, for example, both are information at the physical layer or information at the MAC layer. Alternatively, the information that is about the local model and that is sent by the UE and the information that is about the global model and that is sent by the access network device may be information at different protocol layers. For example, the information that is about the local model and that is sent by the UE is information at the physical layer, and the information that is about the global model and that is sent by the access network device is information at the RRC layer.

For example, the access network device may preconfigure a periodic uplink resource for the UE, and the periodic uplink resource may be used to send information about a local model. In this disclosure, the periodic uplink resource includes, for example, an uplink control channel resource and/or an uplink data channel resource. The uplink control channel resource is, for example, a physical uplink control channel (physical uplink control channel, PUCCH) resource, and the uplink data channel resource is, for example, a physical uplink shared channel (physical uplink shared channel, PUSCH) resource. For example, the access network device may need to receive information about local models from a plurality of UEs, the access network device may uniformly preconfigure periodic uplink resources for the plurality of UEs, or may separately preconfigure periodic uplink resources for different UEs. For example, if a periodic uplink resource configured by the access network device for the first UE is referred to as a first uplink resource, the first UE may send the information about the first local model to the access network device by using the first uplink resource. In addition, if the access network device configures the periodic uplink resource, the access network device may send configuration information to the UE, to indicate the periodic uplink resource. For example, if the access network device configures the first uplink resource for the first UE, the access network device may send first configuration information to the first UE. The first configuration information may be used to configure the first uplink resource. Alternatively, if the access network device configures the first uplink resource for a plurality of UEs, the access network device may broadcast or multicast the first configuration information. The first configuration information may be used to configure the first uplink resource.

Alternatively, the periodic uplink resource may be predefined by a protocol. For example, the periodic uplink resource includes a periodic PUCCH resource, and the UE may send the information about the local model on a part or all of the PUCCH resource. For another example, the periodic uplink resource includes a periodic PUSCH, and the UE may send the information about the local model by using the periodic PUSCH resource.

In this disclosure, the configuration information of the periodic uplink resource includes, for example, one or more of the following: a time domain start position of the periodic uplink resource, a periodicity of the periodic uplink resource, a frequency domain start position of the periodic uplink resource, a frequency domain bandwidth of the periodic uplink resource, a modulation and coding scheme (modulation and coding scheme, MCS) of a channel sent on the periodic uplink resource, or a repeat transmission configuration of the periodic uplink resource. The channel sent on the periodic uplink resource is, for example, a PUSCH or a PUCCH.

Optionally, the access network device may preconfigure a plurality of periodic uplink resources for the UE, or a plurality of periodic uplink resources may be predefined in a protocol, and one periodic uplink resource corresponds to one or more parameter groups. The periodic uplink resource herein is an uplink resource reserved according to a periodicity. For example, for some parameter groups that do not need to be frequently updated, or a parameter group including parameters that change slowly, a long periodicity of a periodic uplink resource may be preconfigured (or predefined) for such a parameter group, to reduce a quantity of times of reporting such a parameter group, and reduce signaling overheads. For a parameter group that needs to be frequently updated, or a parameter group including parameters that change quickly, a short periodicity of a periodic uplink resource may be preconfigured (or predefined) for such a parameter group, to ensure an update frequency of a parameter included in such a parameter group.

Optionally, the time domain start position of the periodic uplink resource may be offset relative to a previous periodic downlink resource by a corresponding time domain distance (for example, the time domain start position of the periodic uplink resource may be offset relative to a time domain start position of the previous periodic downlink resource by a corresponding time domain distance, or the time domain start position of the periodic uplink resource is offset relative to a time domain end position of the previous periodic downlink resource by a corresponding time domain distance, or the time domain start position of the periodic uplink resource is offset relative to another time domain location related to the previous periodic downlink resource by a corresponding time domain distance). For example, for the UE, the time domain start position of the uplink resource used to send the first information of the first local model may be offset by a specific time domain distance relative to a downlink resource used to receive the second information of the global model. For the access network device, the time domain start position of the uplink resource used to receive the first information of the first local model may be offset by a specific time domain distance relative to a downlink resource used to send the second information of the global model. Optionally, the time domain distance includes an integer quantity of symbols, an integer quantity of slots, and/or an integer quantity of subframes. The previous periodic downlink resource is used to send the information about the global model, and the UE performs training after receiving the information about the global model, and then may send the information about the local model by using the periodic uplink resource. Therefore, the time domain start position of the periodic uplink resource is offset relative to the previous periodic downlink resource by a corresponding time domain distance, so that a requirement of sending the information about the local model by the UE in a timely manner can be met. This is reasonable. Alternatively, the time domain start position of the periodic uplink resource may be offset relative to a specific time domain position by a corresponding time domain distance. In this way, the periodic uplink resource is configured more flexibly.

Alternatively, the uplink resource used to send the information about the global model may not be periodic. For example, the access network device preconfigures a downlink control channel resource or a protocol predefines a downlink control channel resource. The access network device may schedule, on the preconfigured downlink control channel resource, the uplink resource used to send the information about the local model, and the uplink resource used to send the information about the local model may be aperiodic. The uplink resource used to send the information about the local model is, for example, an uplink data channel resource and/or an uplink control channel resource. For example, the access network device sends first scheduling information to the first UE on the preconfigured downlink control channel resource. The first scheduling information may be used to schedule the first uplink resource, and the first uplink resource is, for example, a PUSCH resource and/or a PUCCH resource. After receiving the first scheduling information, the first UE may send the information about the first local model on the first uplink resource. This manner is flexible. When the UE needs to send the information about the local model, the access network device may schedule the uplink resource used to send the information about the local model, and when the UE does not need to send the information about the local model, the access network device may not need to schedule the resource, to save transmission resources and improve resource utilization.

In addition, as described above, if the first information of the first local model corresponds to a part of parameters of the first local model, optionally, the first information of the first local model may further include an identifier of the first information of the first local model, or include an identifier of a parameter corresponding to the first information of the first local model. In addition, the identifier of the first information of the first local model, the identifier of the parameter corresponding to the first information of the first local model, or the like may not be included in the first information of the first local model, but may be included in scheduling information used to schedule a downlink resource, for example, included in the first scheduling information described in the previous paragraph. Alternatively, if the first information of the first local model corresponds to the second information of the global model, the UE may not indicate the identifier of the first information of the first local model. For example, neither the first information of the first local model nor the first scheduling information may include the identifier of the first information of the first local model.

The foregoing resource preconfiguration process is mainly preconfiguring an air interface communication resource. In the training process, if the global model is deployed on a core network device, a distributed node configured to train the global model is the access network device, or in the training process, if the global model is deployed on a CU, the distributed node configured to train the global model is a DU. Because wired communication is performed between the core network device and the access network device, and wired communication is also performed between the CU and the DU, optionally, the foregoing resource preconfiguration process may not be performed. The resource preconfiguration process includes the foregoing process of preconfiguring the downlink resource and/or the uplink resource.

For the access network device, a start moment of the first duration is, for example, the H1$^{th}$ time unit after a time domain resource unit in which the information about the global model (for example, the second information of the global model) is sent last time starts. For the UE, a start moment of the first duration is, for example, the H1$^{th}$ time unit after a time domain resource unit in which the information about the global model (for example, the second information of the global model) is received last time starts, and H1 is greater than or equal to 0. A length of the first duration is, for example, H2 time domain resource units, and H2 is greater than 0. Alternatively, if an initial global model is predefined or is downloaded by the UE and the access network device from another device (for example, OAM), in the first round of training, a start moment of the first duration is, for example, a time unit in which current training of the global model starts. The time unit may be agreed upon, configured by the access network device for the UE, or aperiodically triggered by the access network device. This is not limited.

The first duration may be used in one round of model training process. In different rounds of model training processes, the first duration may be used to specify time at which the UE sends the information about the local model and/or time at which the access network device receives the information about the local model. The time domain resource unit may also be referred to as a time domain unit, a time unit, or the like. The time domain resource unit is, for example, a subframe (subframe), a slot (slot), or an orthogonal frequency division multiplexing (orthogonal frequency division multiplexing, OFDM) symbol. For example, a value of H1 and/or a value of H2 are/is preconfigured by the access network device. In this case, the access network device may configure H2 with a same value for a part or all of the K UEs, or the access network device may configure H2 with different values for different UEs. Alternatively, a value of H1 and/or a value of H2 are/is predefined by a protocol. For example, one value of H2 is predefined by the protocol. In this case, the M UEs may all use H2 with the value. Alternatively, a plurality of values of H2 may be predefined by the protocol. Different UEs may use different values of H2, but use manners are similar. Alternatively, a value of H1 and/or a value of H2 may be preconfigured in the first UE. H2 with a same value may be preconfigured for each UE in a part or all of the M UEs, or H2 with different values may be preconfigured for different UEs. In this disclosure, consistency of training processes may be ensured by configuring the value of H2.

For example, the access network device preconfigures the value of H2 for the first UE. For example, the access network device sends first signaling to the first UE. The first signaling is, for example, physical layer signaling, MAC layer signaling, RRC layer signaling, or higher layer signaling, and the first signaling may indicate the value of H2. The first signaling indicates the value of H2, for example, indicates a time window or indicates a timer. A length of the time window is the value of H2, and timing duration of the timer is the value of H2. The first UE may start the time window or the timer indicated by the first signaling in the H1$^{th}$ time unit after a moment (the moment at which the information about the global model is received may be understood as a time point, or may be understood as a time domain resource unit in which the moment at which the information about the global model is received is located) at which the information about the global model is received each time. It may be understood that, for the first UE, a start moment of the first duration may be the H1$^{th}$ time unit after the moment at which the information about the global model is received. The first UE needs to send the information about the first local model after the time window starts or after timing of the timer starts and before the time window ends or before timing of the timer ends. In this disclosure, if an index of a time domain resource unit in which the moment at which the second information of the global model is sent is located is c, an index of the time domain resource unit in which the start moment of the first duration is located is c+H1, and an index of the time domain resource unit in which an end moment of the first duration is located is c+H1+H2. The moment at which the first UE receives the information about the global model is, for example, a moment at which the first UE starts to receive the information about the global model, or a moment at which the first UE completes receiving the information about the global model. It may be considered that the information about the first local model is valid only after the time window starts or after timing of the timer starts and before the time window ends or before timing of the timer ends. If the first UE does not send the information about the first local model before the time window ends or before timing of the timer ends, for example, time of this round of training of the first UE is long, and the time window ends or the timer expires when this round of training is completed, the first UE may not need to send the information about the first local model in this round. That is, the first UE skips a reporting process in this round.

For the access network device, the time window or the timer may also be started in the H1$^{th}$ time unit after a moment at which the information about the global model is sent (the moment at which the information about the global model is sent may be understood as a time point, or may be understood as a time domain resource unit in which the moment at which the information about the global model is sent is located). It may be understood that, for the access network device, the start moment of the first duration may be the H1$^{th}$ time unit after a moment at which the access network device sends the information about the global model last time. A moment at which the access network device sends the information about the global model (for example, H1 is equal to 0) is a moment at which the access network device starts to send the information about the global model, or is a moment at which the access network device completes sending the information about the global model. The access network device may receive information about the M local models from the M UEs. For example, the M UEs jointly use the time window or the timer. If the information about the M local models is all received before the time window ends or before the timer expires, the information about the M local models is all available information, and may participate in a process of updating the global model in this round. However, if information about a part of the M local models is received after the time window ends or after the timer expires, the information about the local models does not participate in a process of updating the global model in this round. For example, the access network device further receives information about N local models from N UEs beyond the first duration. For example, the access network device receives N pieces of first information of the N local models. N is a positive integer, and the N local models one-to-one correspond to the N pieces of first information. "Beyond the first duration", for example, is understood as "after the first duration expires" or "before the first duration starts". For example, in the foregoing example, the index of the time domain resource unit in which the moment at which the second information of the global model is sent is c, the index of the time domain resource unit in which the start moment of the first duration is located is c+H1, and the index of the time domain resource unit in which the end moment of the first duration is located is c+H1+H2. In this case, "beyond the first duration" may be a time domain resource unit after the (c+H1+H2)$^{th}$ time domain resource unit, or a time domain resource unit before the (c+H1)$^{th}$ time domain resource unit. Because the first duration has not started and/or has expired, the access network device may not consider the N pieces of first information of the N local models when updating the global model in this round. For example, the access network device discards the N pieces of first information of the N local models, or the access network device may not discard a part or all of the N pieces of first information of the N local models. First information that is of a local model and that is not discarded does not participate in an update process of the global model, but may have other purposes.

In a manner such as configuring the first duration, synchronization of reporting of local models can be ensured, and the access network device does not confuse training results of different rounds, to improve performance of the global model. For example, if the first duration is less than a periodicity of a periodic downlink resource, or less than a time interval between two rounds of processes of updating the global model, the access network device may collect the local model in the first duration, to obtain the information about the global model, and send the information about the global model on a next downlink transmission opportunity.

S304: The access network device updates the global model based on the M pieces of first information of the M local models.

The access network device obtains the updated global model based on the M pieces of first information of the M local models. For example, the access network device obtains first information of the global model based on the M pieces of first information. The first information of the global model is, for example, information obtained after the global model is updated. In embodiments of this disclosure, it may be understood that for a round of training process (for ease of subsequent description, the round of training process is referred to as a training process A), the second information of the global model is sent by the access network device when the training process A starts (or before the training process A starts), and the second information of the global model may be information obtained after the access network device updates the global model in a previous round of training process (for example, referred to as a training process B) of the training process A. If the training process has not started, that is, the training process B does not exist, the second information of the global model may be initial information of the global model. In other words, the second information of the global model is information about the global model before the access network device updates the global model in the training process A. The first information of the global model is information obtained after the access network device updates the global model in the training process A. For example, before the training process A starts, the access network device sends the second information of the global model. When or after the training process A ends, the access network device sends the first information of the global model. If there is still a next round of training process of the training process A, the access network device sends the first information of the global model before the next round of training process starts. When or after the next round of training process ends, the access network device further sends third information of the global model, and so on.

If all the first information of the M local models is received in the first duration, all the first information of the M local models is available information, and the access network device may obtain the first information of the global model based on the first information of the M local models. If first information of the i$^{th}$ local model in the M pieces of first information of the local model is received before or after the first duration, the access network device does not consider the first information of the i$^{th}$ local model when obtaining the first information of the global model. The first information of the i$^{th}$ local model is from the i$^{th}$ UE in the M UEs. In this disclosure, an example in which the first information of the M local models is all received in the first duration is used. The access network device obtains the first information of the global model based on the first information of the M local models. The first information of the global model may be all information corresponding to the global model, for example, all parameter information corresponding to the global model; or the first information of the global model may be a part of information corresponding to the global model, for example, a part of parameter information corresponding to the global model. For example, the first information of the global model may indicate parameter information of the global model. The parameter information indicated by the first information of the global model may include all parameter information of the global model, or include a part of parameter information of the global model. For another example, the first information of the global model may also indicate a set of differences between a current global model and a previous global model, or indicate a gradient set of a current parameter of the global model and a corresponding parameter of the global model that is sent by the access network device to the UE last time. For this part of content, refer to the foregoing description of the second information of the global model.

Optionally, parameters indicated by the first information of the M local models may be the same. In addition, optionally, a parameter indicated by the first information of the M local models is the same as a parameter indicated by the first information of the global model. For example, all the first information of the M local models corresponds to a first parameter group of the global model, and the access network device may update the first parameter group of the global model based on the first information of the M local models, so that the first information of the obtained global model also corresponds to the first parameter group.

If the first information of the global model corresponds to a part of parameters of the global model, for example, corresponds to the first parameter group of the global model, the access network device may also perform an update process for another parameter of the global model. The update process is similar to an update process of the first parameter group. That is, another UE may send other information of a local model to the access network device, and the other information of the local model may indicate the another parameter of the global model, so that the access network device can update the another parameter of the global model. It should be noted that the UE that sends the other information of the local model to the access network device may be the M UEs, or a part of the M UEs, or UE other than the M UEs, or a part or all of the M UEs and UE other than the M UEs. For example, the M UEs send the M pieces of first information of the M local models to the access network device, the access network device uses the M pieces of first information to train a first part of parameters of the global model. Q UEs send Q pieces of first information of Q local models to the access network device, and the access network device uses the Q pieces of first information to train a second part of parameters of the global model. Q is a positive integer. The Q UEs and the M UEs may include at least one same UE, or may not include any same UE. This is not limited.

A manner in which the access network device obtains the first information of the global model based on the first information of the M local models is as follows: The access network device performs averaging, weighted averaging, or weighted summation on the first information of the M local models, to obtain the first information of the global model. For example, the first information of the M local models indicates M parameter sets, the M parameter sets correspond to the M local models, and one local model corresponds to one parameter set. For example, the M parameter sets are represented as $\theta_1, \theta_2, ..., \theta_M$. For a representation manner of a parameter set of a local model, content included in the parameter set, and the like, refer to the foregoing description. The access network device may obtain an average value of values of a same parameter included in the M parameter sets, so that the M parameter sets can be aggregated into one parameter set. The parameter set is a parameter set of the global model, and the parameter set of the global model may be considered as a parameter set indicated by the first information of the global model. Total quantities of parameters included in different parameter sets in the M parameter sets may be unequal or may be equal. For example, total quantities of parameters included in the M parameter sets are equal. For example, the total quantity is G, G may be equal to or may not be equal to H, and H represents a total quantity of parameters included in a parameter set indicated by the second information of the global model. For example, if G is equal to H, the G parameters and the H parameters may be same parameters, or may not be completely the same or completely different. The parameter set of the global model is, for example, represented as $\Phi = \{\Phi_1, \Phi_2, ... , \Phi_G\}$. For example, if a manner of calculating an average value by the access network device is calculating an arithmetic average value, $$\Phi_g = \frac{1}{M} \times \sum_i \theta_{i,g}$$, $g \in \{1, 2, ... , G\}$, where $\Phi_g$ represents the $g^{th}$ parameter in the parameter set, and $\theta_{i,g}$ represents the $g^{th}$ parameter in a parameter set of a local model that is sent by the $i^{th}$ UE in the M UEs. Alternatively, if a manner of calculating an average value by the access network device may be calculating a weighted average value, $$\Phi_g = \frac{1}{M} \times \sum_i w_i \times \theta_{i,g}$$, $g \in \{1, 2, ... , G\}$, where $w_i$ is a weight of the local model corresponding to the $i^{th}$ UE in the M UEs, and the weight is, for example, configured by the access network device, or predefined by a protocol. Optionally, if a value of $w_i$ is small enough, $\Phi_g$ may also be calculated in the following manner: $\Phi_g = \sum_i w_i \times \theta_{i,g}$, $g \in \{1, 2, ..., G\}$.

For another example, the first information of the M local models is, for example, M gradient sets, the M gradient sets correspond to the M local models, and one local model corresponds to one gradient set. For description of the gradient set, refer to the foregoing description. The access network device may perform averaging, weighted averaging, or weighted summation on the M gradient sets, and an obtained gradient set is referred to as a global gradient set. The access network device may obtain the first information of the global model based on the global gradient set. For example, the access network device may obtain an average value of values of a same parameter included in the M gradient sets, so that the M gradient sets can be aggregated into the global gradient set. Further, the access network device may determine a new parameter set of the global model based on the global gradient set and a parameter set of a previous global model (or a parameter set of the global model obtained in a previous round of training process). The new parameter set of the global model may be considered as a parameter set indicated by the first information of the global model. Total quantities of parameters included in different gradient sets in the M gradient sets may be unequal or may be equal. For example, the total quantities of parameters included in the M gradient sets are equal. For example, if the total quantity is G. The global gradient set is represented as, for example, $\Delta\Phi = \{\Delta\Phi_1, \Delta\Phi_2, ... , \Delta\Phi_G\}$. For example, if a manner of calculating an average value by the access network device is calculating an arithmetic average value,

$$\Delta\Phi_g = \frac{1}{N}\sum_i \Delta\theta_{i,g}$$

, $j \in \{1,2, ..., G\}$, where $\Phi_g$ represents the $g^{th}$ parameter in the global gradient set, and $\Delta\theta_{i,g}$ represents the $g^{th}$ parameter in a gradient set of a local model that is sent by the $i^{th}$ UE in the M UEs. Alternatively, if a manner of calculating an average value by the access network device may be calculating a weighted average value,

$$\Delta\Phi_g = \frac{1}{M} \times$$

$\sum_i w_i \times \Delta\theta_{i,g}$ , $g \in \{1,2, ..., G\}$. Optionally, if a value of $w_i$ is small enough, $\Phi_g$ may also be calculated in the following manner: $\Phi_g = \sum_i w_i \times \Delta\theta_{i,g}$ , $g \in \{1,2, ..., G\}$. For example, the new parameter set that is of the global model and that is obtained by the access network device is represented as $\mathbf{\Phi}^t = \{\Phi_1^t, \Phi_2^t, ..., \Phi_G^t\}$ , that is,

$$\Phi_g^t = \Phi_g^{t-1} + \eta\Delta\Phi_g$$

, $g \in \{1,2, ..., G\}$, where $\eta$ represents a learning rate, and t represents a quantity of training rounds.

S305: The access network device sends the first information of the global model. Correspondingly, a part or all of the K UEs receive the first information of the global model from the access network device. For example, the access network device sends the first information of the global model in a broadcast or multicast manner, or the access network device may separately send the first information of the global model to the K UEs in a unicast manner.

For example, the global model is a cell-level model. The access network device may send the information about the global model in a cell in a broadcast or unicast manner. The K UEs are, for example, all UEs covered by the cell. The M UEs may be a part or all of UEs in the cell. It may be understood that the M UEs are UEs that send the information about the local model to the access network device in the cell in the first duration in one round of training process. For another example, the UEs are grouped, the K UEs are, for example, all UEs included in one UE group, and the M UEs may be a part or all of UEs in the K UEs. Alternatively, there may be another relationship between the M UEs and the K UEs. This is not limited in this disclosure.

In addition, in the foregoing example, all the M UEs belong to the K UEs, or it is possible that a part or all of the M UEs do not belong to the K UEs. For example, a global model is applicable to a group 1 (which is a group of UEs). In a round of training process during one time of training of the global model, all UEs in the group 1 send information about a local model to the access network device. UE 1 belongs to the group 1. In this case, it is considered that the UE 1 is one of the M UEs. However, after the UE 1 sends the information about the local model, the access network device or the UE 1 considers that the UE 1 is more suitable for a group 2 and is not suitable for the group 1. In this case, the UE 1 leaves the group 1 and enters the group 2. Because the global model is applicable to the group 1, when sending information about the global model after the round of training ends, the access network device does not send the information about the global model to the group 2. It is equivalent that the access network device does not send the information about the global model to the UE 1, and the UE 1 does not belong to the K UEs.

For content such as a manner in which the access network device sends the first information of the global model, a protocol layer to which the first information of the global model belongs, and a resource used to send the first information of the global model, refer to the description of sending the second information of the global model by the access network device in S301. After receiving the first information of the global model, the first UE may continue to train the global model based on training data obtained by the first UE, to obtain second information of the first local model. The first UE may then send the second information of the first local model to the access network device. The access network device updates the global model based on the second information of the first local model, and then sends update information of the global model. In other words, S302 to S305 may be repeatedly performed. A processing process of another UE is similar. Optionally, a parameter indicated by the first information of the global model may be the same as a parameter indicated by the second information of the first local model. For these corresponding content, refer to the foregoing description. For example, if a global model obtained by the access network device in a round of training process is converged, the access network device may determine that the training ends. For example, the access network device may send final information of the global model to the UE, and may indicate that the training ends, so that the UE may not need to perform a training process again.

Ideal federated learning requires that local information (for example, a gradient) reporting processes of participants are synchronous. That is, the central node expects to update the global model after receiving all local information. However, due to factors such as different network conditions of different participants or different processing delays of different participants, it is likely that the local information reporting processes of the participants are not synchronous. For example, a plurality of UEs report local information of the $T^{th}$ round to the access network device, and the access network device updates a model of the $T^{th}$ round. In this case, some UEs report local information of the $(T-1)^{th}$ round. If the method disclosed in this disclosure is not used, the access network device may consider the local information of the (T-1)th round as the local information of the Tth round, and aggregate the local information of the (T-1)th round with the other local information of the Tth round. In this case, the outdated local information may affect performance of the model of the Tth round. In this disclosure, the first duration is configured, so that information about a local model can be reported only in the first duration, and the access network device knows when to complete local model collection in a round of training process. This can ensure synchronization between reporting information about local models by UEs, so that the local model matches an update progress of the global model, and performance of the global model is not affected by an outdated local model.

In the embodiment shown in FIG. 3, the first duration is configured, so that synchronization of local models reported by UEs can be achieved, and an update progress of the local model matches that of the global model. In addition, another method may be used to match the update progress of the local model with that of the global model. The following describes a second communication method provided in this disclosure. In the method, a counter is configured, so that an update progress of a local model can also match that of a global model. FIG. 5 is a flowchart of the method.

S501: An access network device sends second information of a global model. Correspondingly, a part or all of K UEs receive the second information of the global model from the access network device. K is a positive integer. The second information of the global model is information before the global model is updated.

When starting machine learning, for example, when starting the first round of training or before starting the first round of training, the access network device may initialize a counter. For example, the counter is referred to as a second counter. The second counter may record a quantity of update times of the global model (the global model is updated once after each round of training, and from this perspective, it may also be considered that the second counter records the quantity of update rounds of the global model). In other words, the second counter may identify the global model. This disclosure is described by using one training process of the global model (one training process may include a plurality of rounds of training processes) as an example. After one training process of the global model is completed, the second counter may be reset, so that the second counter can be used in a next training process. In addition, each of a part or all of UEs participating in training of the global model may also maintain a counter. For example, the counter is referred to as a first counter. The first counter may also identify the global model. After one training process of the global model is completed, the first counter may also be cleared, so that the first counter can be still used in a next training process. If the UEs participating in training of the global model include the K UEs, each of a part or all of the K UEs may maintain a first counter.

In a first optional implementation, an initial value of the second counter is 0 (in this disclosure, an example in which an initial value of a counter is 0 is used, actually, the initial value of the counter may also be another value, and details are not described). Each time the access network device updates the global model, a value of the second counter is increased by 1. Each time the access network device sends the information about the global model (the access network device may update the global model once, and may send the information about the global model once in each round of training process), the access network device also sends the value of the second counter. For example, after receiving the value of the second counter, UE updates a value of a first counter maintained by the UE to the value of the second counter. When sending information about a local model of the UE to the access network device, the UE may also send the value of the first counter maintained by the UE. For example, the UE sends local information to the access network device. The local information may indicate the first counter maintained by the UE and indicate information about the local model of the UE. Before processing the information about the local model of the UE, the access network device may first determine whether the value of the first counter of the UE matches the value of the second counter. For example, if the value of the first counter is the same as the value of the second counter, it is considered that the value of the first counter matches the value of the second counter; or if the value of the first counter is different from the value of the second counter, it is considered that the value of the first counter does not match the value of the second counter. If a value of a first counter of UE matches the value of the second counter, information that is about a local model and that is sent by the UE may participate in an update process of the global model in this round. If a value of a first counter of UE does not match the value of the second counter, information that is about a local model and that is sent by the UE may not participate in the update process of the global model in this round.

For example, in one training process, an initial value of the second counter is 0, and an initial value of the first counter is also 0. In the first round of training process, the access network device sends initial information of the global model and the value of the second counter to the UE. After receiving the value of the second counter, the UE updates the value of the first counter maintained by the UE to the value of the second counter, that is, updates the value of the first counter to 0. In other words, the UE actually keeps the value of the first counter unchanged. The UE further performs training by using the initial information of the global model, to update the local model. In a training process of the UE, values of the first counter and the second counter remain unchanged. The UE sends information about a local model obtained in the first round of training and the value of the first counter to the access network device. The access network device determines whether the value of the first counter is equal to the value of the second counter. In this case, 0 is indeed equal to 0. Therefore, the access network device determines that the value of the first counter matches the value of the second counter, and the information that is about the local model and that is sent by the UE may participate in an update process of the global model in this round. In the second round of training process, the access network device may update the global model based on the information about the local model from the UE, and increase the value of the second counter by 1. In this case, the value of the second counter is changed to 1, and the value of the first counter maintained by the UE is still 0. The access network device sends the value of the second counter and information about an obtained global model to the UE. After receiving the value of the second counter, the UE updates the value of the first counter maintained by the UE to the value of the second counter, that is, updates the value to 1. The UE further performs training by using the information about the global model, to update the local model. In a training process of the UE, values of the first counter and the second counter remain unchanged. The UE sends information about a local model obtained in the second round of training and the value of the first counter to the access network device. The access network device determines whether the value of the first counter is equal to the value of the second counter. In this case, 1 is indeed equal to 1. Therefore, the access network device determines that the value of the first counter matches the value of the second counter, and the information that is about the local model and that is sent by the UE may participate in an update process of the global model in this round. If the global model is not converged, the third round of training may be further performed. A training process is similar. For example, in the third round of training process, the access network device may update the global model based on the information about the local model from the UE, and increase the value of the second counter by 1. In this case, the value of the second counter is changed to 2, and so on. Details are not described again. For the foregoing process, refer to Table 1.

**Table 1**

| | | First counter | Second counter |
|---|---|---|---|
| First round | Initial | Initial value, for example, 0 | Initial value, for example, 0 |
| | The access network device sends the global model and the second counter | Initial value -> Initial value (synchronized as the second counter) | Unchanged, initial value |
| | The UE performs local training | Unchanged, initial value | Unchanged, initial value |
| | The UE sends the local model and the first counter | Unchanged, initial value | Unchanged, initial value Determine whether the first counter is the same as the second counter |
| Second round | The access network device updates the global model | Unchanged, initial value | Initial value -> Initial value+1 |
| | The access network device sends the global model and the second counter | Initial value -> Initial value+1 (synchronized as the second counter) | Unchanged, initial value+1 |
| | The UE performs local training | Unchanged, initial value+1 | Unchanged, initial value+1 |
| | The UE sends the local model and the first counter | Unchanged, initial value+1 | Unchanged, initial value+1 Determine whether the first counter is the same as the second counter |

In a second optional implementation, an initial value of the second counter is 0, and each time the access network device updates the global model, the access network device increases the value of the second counter by 1. Each time the access network device sends the information about the global model, the access network device also sends the value of the second counter. For example, after receiving the value of the second counter, UE may update a value of a first counter maintained by the UE to the value of the second counter, and the UE further performs training based on the first information of the global model to obtain information about a local model. The UE further increases the value of the first counter maintained by the UE by 1. In other words, each time the UE updates the local model, the UE increases the value of the first counter maintained by the UE by 1. When sending the information about the local model of the UE to the access network device (the UE may update the local model once, and may send the information about the local model once in each round of training process), the UE may also send the value of the first counter maintained by the UE. For example, the UE sends local information to the access network device. The local information may indicate the first counter maintained by the UE and indicate information about the local model of the UE. Before processing the information about the local model of the UE, the access network device may first determine whether the value of the first counter of the UE matches the value of the second counter. For example, if the value of the first counter is equal to the value of the second counter plus 1, it is considered that the value of the first counter matches the value of the second counter; or if the value of the first counter is not equal to the value of the second counter plus 1, it is considered that the value of the first counter does not match the value of the second counter. If a value of a first counter of UE matches the value of the second counter, information that is about a local model and that is sent by the UE may participate in an update process of the global model in this round. If a value of a first counter of UE does not match the value of the second counter, information that is about a local model and that is sent by the UE may not participate in the update process of the global model in this round.

For example, in one training process, an initial value of the second counter is 0, and an initial value of the first counter is also 0. In the first round of training process, the access network device sends initial information of the global model and the value of the second counter to the UE. After receiving the value of the second counter, the UE updates the value of the first counter maintained by the UE to the value of the second counter, that is, updates the value of the first counter to 0. In other words, the UE actually keeps the value of the first counter unchanged. The UE further performs training by using the initial information of the global model, to update the local model. In a training process of the UE, values of the first counter and the second counter remain unchanged. After updating the local model, the UE increases the value of the first counter by 1. In this case, the value of the first counter is changed to 1, but the value of the second counter is still 0. The UE sends information about a local model obtained in the first round of training and the value of the first counter to the access network device. The access network device determines whether the value of the first counter is equal to the value of the second counter plus 1. In this case, 1 is indeed equal to 0+1. Therefore, the access network device determines that the value of the first counter matches the value of the second counter, and the information that is about the local model and that is sent by the UE may participate in an update process of the global model in this round. In the second round of training process, the access network device may update the global model based on the information about the local model from the UE, and increase the value of the second counter by 1. In this case, the value of the second counter is changed to 1. The access network device sends the value of the second counter and information about an obtained global model to the UE. After receiving the value of the second counter, the UE updates the value of the first counter maintained by the UE to the value of the second counter, that is, updates the value of the first counter to 1. In other words, the UE actually keeps the value of the first counter unchanged. The UE further performs training by using the information about the global model, to update the local model. In a training process of the UE, values of the first counter and the second counter remain unchanged. After updating the local model, the UE increases the value of the first counter by 1 again. In this case, the value of the first counter is changed to 2, but the value of the second counter is still 1. The UE sends information about a local model obtained in the second round of training and the value of the first counter to the access network device. The access network device determines whether the value of the first counter is equal to the value of the second counter plus 1. In this case, 2 is indeed equal to 1+1. Therefore, the access network device determines that the value of the first counter matches the value of the second counter, and the information that is about the local model and that is sent by the UE may participate in an update process of the global model in this round. If the global model is not converged, the third round of training may be further performed. A training process is similar. For example, in the third round of training process, the access network device may update the global model based on the information about the local model from the UE, and increase the value of the second counter by 1. In this case, the value of the second counter is changed to 2, and so on. Details are not described again. For the foregoing process, refer to Table 2.

**Table 2**

| | | First counter | Second counter |
|---|---|---|---|
| First round | Initial | Initial value, for example, 0 | Initial value, for example, 0 |
| | The access network device sends the global model and the second counter | Initial value -> Initial value (synchronized as the second counter) | Unchanged, initial value |
| | The UE performs local training | Initial value -> Initial value+1 | Unchanged, initial value |
| | The UE sends the local model and the first counter | Unchanged, initial value+1 | Unchanged, initial value Determine whether the first counter is equal to the second counter+1 |

(continued)

| | | | First counter | Second counter |
|---|---|---|---|---|
| Second round | The access network device updates the global model | | Unchanged, initial value+1 | Initial value -> Initial value+1 |
| | The access network device sends the global model and the second counter | | Initial value+1 -> Initial value+1 (synchronized as the second counter) | Unchanged, initial value+1 |
| | The UE performs local training | | Initial value+1 -> Initial value+2 | Unchanged, initial value+1 |
| | The UE sends the local model and the first counter | | Unchanged, initial value+2 | Unchanged, initial value+1 Determine whether the first counter is equal to the second counter+1 |

In a third optional implementation, an initial value of the second counter is 0, and the access network device may not change a value of the second counter when updating the global model. However, after the access network device receives a value of a first counter from UE, if the value of the first counter matches the value of the second counter, the access network device updates the value of the second counter to the value of the first counter that matches the second counter (for example, the access network device may receive values of a plurality of first counters from a plurality of UEs, and if values of all first counters that match the second counter should be the same, for example, equal to the value of the second counter plus 1, the access network device updates the value of the second counter to the value of the first counter). Each time the access network device sends the information about the global model, the access network device also sends the value of the second counter. For example, after receiving the value of the second counter, UE may update a value of a first counter maintained by the UE to the value of the second counter, and the UE further performs training based on the first information of the global model to obtain information about a local model. The UE further increases the value of the first counter maintained by the UE by 1. In other words, each time the UE updates the local model, the UE increases the value of the first counter maintained by the UE by 1. When sending the information about the local model of the UE to the access network device (the UE may update the local model once, and may send the information about the local model once in each round of training process), the UE may also send the value of the first counter maintained by the UE. For example, the UE sends local information to the access network device. The local information may indicate the first counter maintained by the UE and indicate information about the local model of the UE. Before processing the information about the local model of the UE, the access network device may first determine whether the value of the first counter of the UE matches the value of the second counter. For example, if the value of the first counter is equal to the value of the second counter plus 1, it is considered that the value of the first counter matches the value of the second counter; or if the value of the first counter is not equal to the value of the second counter plus 1, it is considered that the value of the first counter does not match the value of the second counter. If a value of a first counter of UE matches the value of the second counter, information that is about a local model and that is sent by the UE may participate in an update process of the global model in this round. If a value of a first counter of UE does not match the value of the second counter, information that is about a local model and that is sent by the UE may not participate in the update process of the global model in this round.

For example, in one training process, an initial value of the second counter is 0, and an initial value of the first counter is also 0. In the first round of training process, the access network device sends initial information of the global model and the value of the second counter to the UE. After receiving the value of the second counter, the UE updates the value of the first counter maintained by the UE to the value of the second counter, that is, updates the value of the first counter to 0. In other words, the UE actually keeps the value of the first counter unchanged. The UE further performs training by using the initial information of the global model, to update the local model. In a training process of the UE, values of the first counter and the second counter remain unchanged. After the training ends, the UE increases the value of the first counter by 1. In this case, the value of the first counter is changed to 1, but the value of the second counter is still 0. The UE sends information about a local model obtained in the first round of training and the value of the first counter to the access network device. The access network device determines whether the value of the first counter is equal to the value of the second counter plus 1. In this case, 1 is indeed equal to 0+1. Therefore, the access network device determines that the value of the first counter matches the value of the second counter, and the information that is about the local model and that is sent by the UE may participate in an update process of the global model in this round. In addition, the access network device updates the value of the second counter to the value of the first counter that matches the second counter. If the value of the first counter that matches the second counter is 1, the access network device updates the value of the second counter to 1. In the second round of training process, the access network device may update the global model based on the information about the local model from the UE, and keep the value of the second counter unchanged. That is, the value of the second counter is still 1. The access network device sends the value of the second counter and information about an obtained global model to the UE. After receiving the value of the second counter, the UE updates the value of the first counter maintained by the UE to the value of the second counter, that is, updates the value of the first counter to 1. In other words, the UE actually keeps the value of the first counter unchanged. The UE further performs training by using the information about the global model, to update the local model. In a training process of the UE, values of the first counter and the second counter remain unchanged. After the training ends, the UE increases the value of the first counter by 1 again. In this case, the value of the first counter is changed to 2, but the value of the second counter is still 1. The UE sends information about a local model obtained in the second round of training and the value of the first counter to the access network device. The access network device determines whether the value of the first counter is equal to the value of the second counter plus 1. In this case, 2 is indeed equal to 1+1. Therefore, the access network device determines that the value of the first counter matches the value of the second counter, and the information that is about the local model and that is sent by the UE may participate in an update process of the global model in this round. In addition, the access network device updates the value of the second counter to the value of the first counter that matches the second counter. If the value of the first counter that matches the second counter is 2, the access network device updates the value of the second counter to 2. If the global model is not converged, the third round of training may be further performed. A training process is similar. For example, in the third round of training process, the access network device may update the global model based on the information about the local model from the UE, and keep the value of the second counter unchanged, and so on. Details are not described again. For the foregoing process, refer to Table 3.

**Table 3**

| | | First counter | Second counter |
|---|---|---|---|
| First round | Initial | Initial value, for example, 0 | Initial value, for example, 0 |
| | The access network device sends the global model and the second counter | Initial value -> Initial value (synchronized as the second counter) | Unchanged, initial value |
| | The UE performs local training | Initial value -> Initial value+1 | Unchanged, initial value |
| | The UE sends the local model and the first counter | Unchanged, initial value+1 | Determine whether the counter of the UE is equal to the second counter+1 Initial value -> Initial value+1 (synchronized as the first counter) |
| Second round | The access network device updates the global model | Unchanged, initial value+1 | Unchanged, initial value+1 |
| | The access network device sends the global model and the second counter | Initial value+1 -> Initial value+1 (synchronized as the second counter) | Unchanged, initial value+1 |
| | The UE performs local training | Initial value+1 -> Initial value+2 | Unchanged, initial value+1 |
| | The UE sends the local model and the first counter | Unchanged, initial value+2 | Determine whether the counter of the UE is equal to the second counter+1 Initial value+1 -> Initial value+2 (synchronized as the first counter) |

In the second optional implementation and the third optional implementation, implementation results are equivalent. A difference lies in that in an implementation process, in the second optional implementation, the access network device actively increases the value of the second counter by 1 when updating the global model, and in the third optional implementation, after determining that the first counter matches the second counter, the access network device synchronizes the second counter as a counter of matched UE.

In a fourth optional implementation, a value of a counter may also be determined based on a time unit. For example, the value of the second counter does not need to be sent by the access network device. The UE may determine the value of the second counter based on a time unit for receiving the information about the global model, and the access network device may determine the value of the second counter based on a time unit for sending the information about the global model. For example, for the UE, the value of the second counter is an index of the time unit for receiving the information about the global model, and for the access network device, the value of the second counter is an index of the time unit for sending the information about the global model. After determining the value of the second counter, the UE updates the value of the first counter maintained by the UE to the value of the second counter. When sending information about a local model of the UE to the access network device, the UE may also send the value of the first counter maintained by the UE. For example, the UE sends local information to the access network device. The local information may indicate the first counter maintained by the UE and indicate information about the local model of the UE. Before processing the information about the local model of the UE, the access network device may first determine whether the value of the first counter of the UE matches the value of the second counter. For example, if a difference between the value of the first counter and the value of the second counter is less than or equal to a second threshold, it is considered that the value of the first counter matches the value of the second counter; or if a difference between the value of the first counter and the value of the second counter is greater than a second threshold, it is considered that the value of the first counter does not match the value of the second counter. The second threshold is greater than or equal to 0. If a value of a first counter of UE matches the value of the second counter, information that is about a local model and that is sent by the UE may participate in an update process of the global model in this round. If a value of a first counter of UE does not match the value of the second counter, information that is about a local model and that is sent by the UE may not participate in the update process of the global model in this round.

The foregoing description of the solution of the first counter and the second counter is based on a premise that the parameters of the model are not separately sent. If the parameters of the model are separately sent (for example, the information about the global model may correspond to a part of parameters of the global model, and/or the information about the local model may correspond to a part of parameters of the local model, and for this, refer to the description of the embodiment shown in FIG. 3), a solution of the counter may be correspondingly changed, and the following provides description.

For example, when starting machine learning, for example, when starting the first round of training or before starting the first round of training, the access network device may initialize one or more second counters. One second counter corresponds to one parameter group of the global model, and the second counter may record a quantity of update times of a corresponding parameter group (the parameter group is updated once after each round of training, and from this perspective, it may also be considered that the second counter records the quantity of update rounds of the parameter group). In addition, each of a part or all of UEs that receive the first information of the global model may also maintain one or more first counters. One first counter corresponds to one parameter group of the global model (or corresponds to a local model maintained by the UE). A quantity of first counters maintained by UE may be equal to a quantity of second counters maintained by the access network device, and the first counters one-to-one correspond to the second counters. Correspondence herein means that if one first counter and one second counter both correspond to a same parameter group, the first counter corresponds to the second counter.

In an optional implementation, an initial value of a second counter A corresponding to a parameter group A of the global model is 0, and each time the access network device updates the parameter group A, the access network device increases the value of the second counter A by 1. When sending the first information of the global model, the access network device may send only a value of a second counter corresponding to an updated parameter group, or may send values of second counters corresponding to all parameter groups. After receiving a value of a second counter, UE updates a value of a first counter maintained by the UE to the value of the second counter. For example, the access network device sends the value of the second counter A when sending the second information of the global model. After receiving the value of the second counter A, UE may update a value of a first counter A maintained by the UE to the value of the second counter A. The first counter A corresponds to the parameter group A. When sending information about a local model of the UE to the access network device, the UE may send only a value of a first counter corresponding to an updated parameter group, or may send values of first counters corresponding to all parameter groups. Before processing the information about the local model of the UE, the access network device may first determine whether the value of the first counter of the UE matches the value of the corresponding second counter. For example, if the value of the first counter is the same as the value of the corresponding second counter, it is considered that the value of the first counter matches the value of the second counter; or if the value of the first counter is different from the value of the corresponding second counter, it is considered that the value of the first counter does not match the value of the second counter. If a value of a first counter of UE matches a value of a corresponding second counter, information that is about a local model and that is sent by the UE may participate in an update process of the global model in this round. If a value of at least one first counter of UE does not match a value of a corresponding second counter, information that is about a local model and that is sent by the UE may not participate in the update process of the global model in this round.

For example, in one training process, an initial value of a second counter corresponding to each parameter group of the global model is 0. For example, a total quantity of second counters is 2, and the second counters are the second counter A and a second counter B. The second counter A corresponds to the parameter group A of the global model, and the second counter B corresponds to a parameter group B of the global model. In addition, an initial value of a first counter corresponding to each parameter group of the local model of the UE is also 0. For example, a total quantity of first counters is 2, and the first counters are the first counter A and a first counter B. The first counter A corresponds to a parameter group A of the local model, and the first counter B corresponds to a parameter group B of the local model. In the first round of training process, the access network device sends the initial information of the global model, the value of the second counter A, and the value of the second counter B to the UE. After receiving the value of the second counter A and the value of the second counter B, the UE updates the value of the first counter A maintained by the UE to the value of the second counter A, and updates the value of the first counter B maintained by the UE to the value of the second counter B, that is, updates both the values to 0. In other words, the UE actually keeps the value of the first counter A and the value of the first counter B unchanged. The UE further performs training by using the initial information of the global model. The initial information of the global model includes, for example, initial information of the parameter group A. The UE performs training by using the initial information of the parameter group A, to update the local model. In a training process of the UE, values of the first counter and the second counter remain unchanged. The UE sends information (for example, information 1 of the parameter group A) about a local model obtained in this round of training, the value of the first counter A, and the value of the first counter B to the access network device. The access network device determines whether the value of the first counter A is equal to the value of the second counter A. In this case, both values are 0. The access network device determines whether the value of the first counter B is equal to the value of the second counter B. In this case, both values are 0. Therefore, the access network device determines that the value of the first counter matches the value of the second counter, and the information 1 that is of the parameter group A and that is sent by the UE may participate in an update process of the global model in this round. In the second round of training process, the access network device may update the global model (for example, obtain information 2 of the parameter group A) based on the information 1 of the parameter group A from the UE, and increase the value of the second counter A by 1. The value of the second counter A is changed to 1, and the value of the second counter B is still 0. The access network device sends the value of the second counter A, the value of the second counter B, and the obtained information 2 of the parameter group A to the UE. After receiving the value of the second counter A and the value of the second counter B, the UE updates the value of the first counter A maintained by the UE to the value of the second counter A, that is, updates the value to 1, and updates the value of the first counter B maintained by the UE to the value of the second counter B, that is, updates the value to 0, or keeps the value of the first counter B unchanged. The UE further performs training by using the information 2 of the parameter group A, to update the local model. For example, the UE updates the parameter group A of the local model, and obtains information 3 of the parameter group A. In a training process of the UE, values of the first counter and the second counter remain unchanged. The UE sends the information about the parameter group A obtained in this round of training, the value of the first counter A, and the value of the first counter B to the access network device. The access network device determines whether the value of the first counter A is equal to the value of the second counter A, and determines whether the value of the first counter B is equal to the value of the second counter B. In this case, the value of the first counter A is 1, and is equal to the value 1 of the second counter A. Values of the first counter B and the second counter B are both 0. Therefore, the access network device determines that the value of the first counter of the UE matches the value of the second counter, and the information 3 that is of the parameter group A and that is sent by the UE may participate in an update process of the global model in this round. If the global model is not converged, the third round of training may be further performed. A training process is similar. For example, in the third round of training process, the access network device may update the global model based on the information about the parameter group A from the UE, and increase the value of the second counter A by 1. In this case, the value of the second counter A is changed to 2. If the access network device does not train the parameter group B, the value of the second counter B remains unchanged, and so on. Details are not described. For the foregoing process, refer to Table 4.

**Table 4**

| | | | First counter A | First counter B | Second counter A | Second counter B |
|---|---|---|---|---|---|---|
| First round | Initial | | Initial value, for example, 0 | Initial value, for example, 0 | Initial value, for example, 0 | Initial value, for example, 0 |
| | The access network device sends the global model, the second counter A, and the second counter B | | Initial value -> Initial value (synchronized as the second counter A) | Initial value -> Initial value (synchronized as the second counter B) | Unchanged, initial value | Unchanged, initial value |
| | The UE performs local training | | Unchanged, initial value | Unchanged, initial value | Unchanged, initial value | Unchanged, initial value |
| | The UE sends the local model, the first counter A, and the first counter B | | Unchanged, initial value | Unchanged, initial value | Unchanged, initial value Determine whether the first counter A is equal to the second counter A | Unchanged, initial value Determine whether the first counter B is equal to the second counter B |
| Second round | The access network device updates the global model | | Unchanged, initial value | Unchanged, initial value | Initial value -> Initial value+1 | Unchanged, initial value |
| | The access network device sends the global model, the second counter A, and the second counter B | | Initial value -> Initial value+1 (synchronized as the second counter A) | Unchanged, initial value (synchronized as the second counter B) | Unchanged, initial value+1 | Unchanged, initial value |
| | The UE performs local training | | Unchanged, initial value+1 | Unchanged, initial value | Unchanged, initial value+1 | Unchanged, initial value |
| | The UE sends the local model, the first counter A, and the first counter B | | Unchanged, initial value+1 | Unchanged, initial value | Unchanged, initial value+1 Determine whether the first counter A is equal to the second counter A | Unchanged, initial value Determine whether the first counter B is equal to the second counter B |

In another optional implementation, an initial value of a second counter A corresponding to a parameter group A of the global model is 0, and each time the access network device updates the parameter group A, the access network device increases the value of the second counter A by 1. When sending the information about the global model, the access network device may send only a value of a second counter corresponding to an updated parameter group, or may send values of second counters corresponding to all parameter groups. After receiving a value of a second counter, UE updates a value of a first counter maintained by the UE to the value of the second counter. For example, the access network device sends the value of the second counter A when sending the second information of the global model. After receiving the value of the second counter A, UE may update a value of a first counter A maintained by the UE to the value of the second counter A. The first counter A corresponds to the parameter group A. In addition, the UE further performs training based on the second information of the global model to obtain information about a local model (if the first information of the global model corresponds to a part of parameter groups, the UE trains only parameters included in the part of parameter groups, and parameters in another parameter group remain unchanged), and the UE further increases a value of a first counter corresponding to a trained parameter group by 1. When sending information about a local model of the UE to the access network device, the UE may send only a value of a first counter corresponding to an updated parameter group, or may send values of first counters corresponding to all parameter groups. Before processing the information about the local model of the UE, the access network device may first determine whether the value of the first counter of the UE matches a value of a corresponding second counter. For example, for the first counter and the second counter corresponding to the updated parameter group, if the value of the first counter is equal to the value of the corresponding second counter plus 1, it is considered that the value of the first counter matches the value of the second counter; or if the value of the first counter is not equal to the value of the corresponding second counter plus 1, it is considered that the value of the first counter does not match the value of the second counter. For another example, for a first counter and a second counter corresponding to a parameter group that is not updated, if a value of the first counter is equal to a value of the corresponding second counter, it is considered that the value of the first counter matches the value of the second counter; or if a value of the first counter is not equal to a value of a corresponding second counter, it is considered that the value of the first counter does not match the value of the second counter. If a value of a first counter of UE matches a value of a corresponding second counter, information that is about a local model and that is sent by the UE may participate in an update process of the global model in this round. If a value of at least one first counter of UE does not match a value of a corresponding second counter, information that is about a local model and that is sent by the UE may not participate in the update process of the global model in this round.

For example, in one training process, an initial value of a second counter corresponding to each parameter group of the global model is 0. For example, a total quantity of second counters is 2, and the second counters are the second counter A and a second counter B. The second counter A corresponds to the parameter group A of the global model, and the second counter B corresponds to a parameter group B of the global model. In addition, an initial value of a first counter corresponding to each parameter group of the local model of the UE is also 0. For example, a total quantity of first counters is 2, and the first counters are the first counter A and a first counter B. The first counter A corresponds to a parameter group A of the local model, and the first counter B corresponds to a parameter group B of the local model. In the first round of training process, the access network device sends the initial information of the global model, the value of the second counter A, and the value of the second counter B to the UE. After receiving the value of the second counter A and the value of the second counter B, the UE updates the value of the first counter A maintained by the UE to the value of the second counter A, and updates the value of the first counter B maintained by the UE to the value of the second counter B, that is, updates both the values to 0. In other words, the UE actually keeps the value of the first counter A and the value of the first counter B unchanged. The UE further performs training by using the initial information of the global model. The initial information of the global model includes, for example, initial information of the parameter group A. The UE performs training by using the initial information of the parameter group A, to update the local model. In a training process of the UE, values of the first counter and the second counter remain unchanged. After updating the local model, the UE increases the value of the first counter A by 1. In this case, the value of the first counter A is changed to 1, but the value of the second counter A, the value of the second counter B, and the value of the first counter B are still 0. The UE sends information (for example, information 1 of the parameter group A) about a local model, the value of the first counter A, and the value of the first counter B to the access network device. The access network device determines whether the value of the first counter A is equal to the value of the second counter A plus 1. In this case, 1 is indeed equal to 0+1. The access network device determines whether the value of the first counter B is equal to the value of the second counter B. In this case, both values are 0. Therefore, the access network device determines that the value of the first counter matches the value of the second counter, and the information 1 that is of the parameter group A and that is sent by the UE may participate in an update process of the global model in this round. In the second round of training process, the access network device may update the global model (for example, obtain information 2 of the parameter group A) based on the information 1 of the parameter group A from the UE, and increase the value of the second counter A by 1. The value of the second counter A is changed to 1, and the value of the second counter B is still 0. The access network device sends the value of the second counter A, the value of the second counter B, and the obtained information 2 of the parameter group A to the UE. After receiving the value of the second counter A and the value of the second counter B, the UE updates the value of the first counter A maintained by the UE to the value of the second counter A, that is, updates the value to 1, and updates the value of the first counter B maintained by the UE to the value of the second counter B, that is, updates the value to 0, or keeps the value of the first counter B unchanged. The UE further performs training by using the information 2 of the parameter group A, to update the local model. For example, the UE updates the parameter group A of the local model, and obtains information 3 of the parameter group A. In a training process of the UE, values of the first counter and the second counter remain unchanged. After updating the local model, the UE increases the value of the first counter A by 1. In this case, the value of the first counter A is changed to 2, the value of the second counter A is still 1, and values of the first counter B and the second counter B remain unchanged. The UE sends the information about the parameter group A, the value of the first counter A, and the value of the first counter B to the access network device. The access network device determines whether the value of the first counter A is equal to the value of the second counter A plus 1, and determines whether the value of the first counter B is equal to the value of the second counter B. In this case, the value of the first counter A is 2, and is equal to the value 1 of the second counter A plus 1. Values of the first counter B and the second counter B are both 0. Therefore, the access network device determines that the value of the first counter of the UE matches the value of the second counter, and the information 3 that is of the parameter group A and that is sent by the UE may participate in an update process of the global model in this round. If the global model is not converged, the third round of training may be further performed. A training process is similar. For example, in the third round of training process, the access network device may update the global model based on the information about the parameter group A from the UE, and increase the value of the second counter A by 1. In this case, the value of the second counter A is changed to 2. If the access network device does not train the parameter group B, the value of the second counter B remains unchanged, and so on. Details are not described. For the foregoing process, refer to Table 5.

**Table 5**

| | | | First counter A | First counter B | Second counter A | Second counter B |
|---|---|---|---|---|---|---|
| First round | Initial | | Initial value, for example, 0 | Initial value, for example, 0 | Initial value, for example, 0 | Initial value, for example, 0 |
| | The access network device sends the global model, the second counter A, and the second counter B | | Initial value -> Initial value (synchronized as the second counter A) | Initial value -> Initial value (synchronized as the second counter B) | Unchanged, initial value | Unchanged, initial value |
| | The UE performs local training | | Initial value -> Initial value+1 | Unchanged, initial value | Unchanged, initial value | Unchanged, initial value |
| | The UE sends the local model, the first counter A, and the first counter B | | Unchanged, initial value+1 | Unchanged, initial value | Unchanged, initial value Determine whether the first counter A is equal to the second counter A+1 | Unchanged, initial value Determine whether the first counter B is equal to the second counter B |
| Second round | The access network device updates the global model | | Unchanged, initial value+1 | Unchanged, initial value | Initial value -> Initial value+1 | Unchanged, initial value |
| | The access network device sends the global model, the second counter A, and the second counter B | | Initial value+1 -> Initial value+1 (synchronized as the second counter A) | Unchanged, initial value (synchronized as the second counter B) | Unchanged, initial value+1 | Unchanged, initial value |
| | The UE performs local training | | Initial value+1 -> Initial value+2 | Unchanged, initial value | Unchanged, initial value+1 | Unchanged, initial value |
| | The UE sends the local model, the first counter A, and the first counter B | | Unchanged, initial value+2 | Unchanged, initial value | Unchanged, initial value+1 Determine whether the first counter A is equal to the second counter A+1 | Unchanged, initial value Determine whether the first counter B is equal to the second counter B |

In still another optional implementation, an initial value of a second counter A corresponding to a parameter group A of the global model is 0, and when updating the parameter group A, the access network device keeps the value of the second counter A unchanged. However, after the access network device receives a value of a first counter A from UE, if the value of the first counter A matches the value of the second counter A, the access network device updates the value of the second counter A to the value of the first counter A that matches the second counter A (for example, the access network device may receive values of a plurality of first counters A from a plurality of UEs, and if values of all first counters A that match the second counter A should be the same, for example, equal to the value of the second counter A plus 1, the access network device updates the value of the second counter A to the value of the first counter A). When sending the information about the global model, the access network device may send only a value of a second counter corresponding to an updated parameter group, or may send values of second counters corresponding to all parameter groups. After receiving a value of a second counter, UE updates a value of a first counter maintained by the UE to the value of the second counter. For example, the access network device sends the value of the second counter A when sending the second information of the global model. After receiving the value of the second counter A, UE may update a value of a first counter A maintained by the UE to the value of the second counter A. The first counter A corresponds to the parameter group A. In addition, the UE further performs training based on the second information of the global model to obtain information about a local model (if the first information of the global model corresponds to a part of parameter groups, the UE trains only parameters included in the part of parameter groups, and parameters in another parameter group remain unchanged), and the UE further increases a value of a first counter corresponding to a trained parameter group by 1. When sending information about a local model of the UE to the access network device, the UE may send only a value of a first counter corresponding to an updated parameter group, or may send values of first counters corresponding to all parameter groups. Before processing the information about the local model of the UE, the access network device may first determine whether the value of the first counter of the UE matches a value of a corresponding second counter. For example, for the first counter and the second counter corresponding to the updated parameter group, if the value of the first counter is equal to the value of the corresponding second counter plus 1, it is considered that the value of the first counter matches the value of the second counter; or if the value of the first counter is not equal to the value of the corresponding second counter plus 1, it is considered that the value of the first counter does not match the value of the second counter. For another example, for a first counter and a second counter corresponding to a parameter group that is not updated, if a value of the first counter is equal to a value of the corresponding second counter, it is considered that the value of the first counter matches the value of the second counter; or if a value of the first counter is not equal to a value of the corresponding second counter, it is considered that the value of the first counter does not match the value of the second counter. If a value of a first counter of UE matches a value of a corresponding second counter, information that is about a local model and that is sent by the UE may participate in an update process of the global model in this round. If a value of at least one first counter of UE does not match a value of a corresponding second counter, information that is about a local model and that is sent by the UE may not participate in the update process of the global model in this round.

For example, in one training process, an initial value of a second counter corresponding to each parameter group of the global model is 0. For example, a total quantity of second counters is 2, and the second counters are the second counter A and a second counter B. The second counter A corresponds to the parameter group A of the global model, and the second counter B corresponds to a parameter group B of the global model. In addition, an initial value of a first counter corresponding to each parameter group of the local model of the UE is also 0. For example, a total quantity of first counters is 2, and the first counters are the first counter A and a first counter B. The first counter A corresponds to a parameter group A of the local model, and the first counter B corresponds to a parameter group B of the local model. In the first round of training process, the access network device sends the initial information of the global model, the value of the second counter A, and the value of the second counter B to the UE. After receiving the value of the second counter A and the value of the second counter B, the UE updates the value of the first counter A maintained by the UE to the value of the second counter A, and updates the value of the first counter B maintained by the UE to the value of the second counter B, that is, updates both the values to 0. In other words, the UE actually keeps the value of the first counter A and the value of the first counter B unchanged. The UE further performs training by using the initial information of the global model. The initial information of the global model includes, for example, initial information of the parameter group A. The UE performs training by using the initial information of the parameter group A, to update the local model. In a training process of the UE, values of the first counter and the second counter remain unchanged. After updating the local model, the UE increases the value of the first counter A by 1. In this case, the value of the first counter A is changed to 1, but the value of the second counter A, the value of the second counter B, and the value of the first counter B are still 0. The UE sends information (for example, information 1 of the parameter group A) about a local model, the value of the first counter A, and the value of the first counter B to the access network device. The access network device determines whether the value of the first counter A is equal to the value of the second counter A plus 1. In this case, 1 is indeed equal to 0+1. The access network device determines whether the value of the first counter B is equal to the value of the second counter B. In this case, both values are 0. Therefore, the access network device determines that the value of the first counter matches the value of the second counter, and the information 1 that is of the parameter group A and that is sent by the UE may participate in an update process of the global model in this round. The access network device updates the value of the second counter A to the value of the first counter A that matches the value of the second counter A, the value of the first counter A that matches the value of the second counter A is 1, and the access network device updates the value of the second counter A to 1. The access network device updates the value of the second counter B to the value of the first counter B that matches the value of the second counter B, and the value of the first counter B that matches the value of the second counter B is 0, and the access network device updates the value of the second counter B to 0, or in other words the access network device keeps the value of the second counter B unchanged. In the second round of training process, the access network device may update the global model (for example, obtain information 2 of the parameter group A) based on the information 1 of the parameter group A from the UE, and the access network device keeps the value of the second counter A and the value of the second counter B unchanged. That is, the value of the second counter is 1, and the value of the second counter B is 0. The access network device sends the value of the second counter A, the value of the second counter B, and the obtained information 2 of the parameter group A to the UE. After receiving the value of the second counter A and the value of the second counter B, the UE updates the value of the first counter A maintained by the UE to the value of the second counter A, that is, updates the value to 1, and updates the value of the first counter B maintained by the UE to the value of the second counter B, that is, updates the value to 0, or in other words, the UE keeps the value of the first counter B unchanged. The UE further performs training by using the information 2 of the parameter group A, to update the local model. For example, the UE updates the parameter group A of the local model, and obtains information 3 of the parameter group A. In a training process of the UE, values of the first counter and the second counter remain unchanged. After updating the local model, the UE increases the value of the first counter A by 1. In this case, the value of the first counter A is changed to 2, the value of the second counter A is still 1, and values of the first counter B and the second counter B remain unchanged. The UE sends the information about the parameter group A, the value of the first counter A, and the value of the first counter B to the access network device. The access network device determines whether the value of the first counter A is equal to the value of the second counter A plus 1, and determines whether the value of the first counter B is equal to the value of the second counter B. In this case, the value of the first counter A is 2, and is equal to the value 1 of the second counter A plus 1. Values of the first counter B and the second counter B are both 0. Therefore, the access network device determines that the value of the first counter of the UE matches the value of the second counter, and the information 3 that is of the parameter group A and that is sent by the UE may participate in an update process of the global model in this round. The access network device updates the value of the second counter A to the value of the first counter A that matches the value of the second counter A, the value of the first counter A that matches the value of the second counter A is 2, and the access network device updates the value of the second counter A to 2. The access network device updates the value of the second counter B to the value of the first counter B that matches the value of the second counter B, and the value of the first counter B that matches the value of the second counter B is 0, and the access network device updates the value of the second counter B to 0, or in other words the access network device keeps the value of the second counter B unchanged. If the global model is not converged, the third round of training may be further performed. A training process is similar. For example, in the third round of training process, the access network device may update the global model based on the information about the parameter group A from the UE, and keep the value of the second counter A and the value of the second counter B unchanged, and so on. Details are not described again. For the foregoing process, refer to Table 6.

**Table 6**

| | | | First counter A | First counter B | Second counter A | Second counter B |
|---|---|---|---|---|---|---|
| First round | Initial | | Initial value, for example, 0 | Initial value, for example, 0 | Initial value, for example, 0 | Initial value, for example, 0 |
| | The access network device sends the global model, the second counter A, and the second counter B | | Initial value -> Initial value (synchronized as the second counter A) | Initial value -> Initial value (synchronized as the second counter B) | Unchanged, initial value | Unchanged, initial value |
| | The UE performs local training | | Initial value -> Initial value+1 | Unchanged, initial value | Unchanged, initial value | Unchanged, initial value |
| | The UE sends the local model, the first counter A, and the first counter B | | Unchanged, initial value+1 | Unchanged, initial value | Unchanged, initial value Determine whether the first counter A is equal to the second counter A + 1 Initial value -> Initial value+1 (synchronized as the first counter A) | Unchanged, initial value Determine whether the first counter B is equal to the second counter B Initial value -> Initial value (synchronized as the first counter B) |

(continued)

|  |  | First counter A | First counter B | Second counter A | Second counter B |
|---|---|---|---|---|---|
| Second round | The access network device updates the global model | Unchanged, initial value+1 | Unchanged, initial value | Unchanged, initial value+1 | Unchanged, initial value |
|  | The access network device sends the global model, the second counter A, and the second counter B | Initial value+1 -> Initial value+1 (synchronized as the second counter A) | Unchanged, initial value (synchronized as the second counter B) | Unchanged, initial value+1 | Unchanged, initial value |
|  | The UE performs local training | Initial value+1 -> Initial value+2 | Unchanged, initial value | Unchanged, initial value+1 | Unchanged, initial value |
|  | The UE sends the local model, the first counter A, and the first counter B | Unchanged, initial value+2 | Unchanged, initial value | Unchanged, initial value+1 Determine whether the first counter A is equal to the second counter A + 1 Initial value+1 -> Initial value+2 (synchronized as the first counter A) | Unchanged, initial value Determine whether the first counter B is equal to the second counter B Initial value -> Initial value (synchronized as the first counter A) |

In still another optional implementation, a value of the counter may also be determined based on a time unit. For an implementation, refer to the foregoing description.

In the foregoing manner, it can be ensured that a quantity of rounds of updating the local model matches a quantity of rounds of updating the global model, so that an outdated local model does not affect performance of the global model.

For more content of S501, refer to S301 in the embodiment shown in FIG. 3. In addition, S501 is an optional step, and is represented by a dashed line in FIG. 5.

S502: The first UE trains the global model to obtain a first local model. The first UE may obtain the first local model, for example, obtain first information of the first local model. Optionally, the first information of the first local model, for example, corresponds to the first information of the global model. For example, a parameter corresponding to the first information of the global model is the same as a parameter corresponding to the first information of the first local model.

The first UE is, for example, one of the K UEs. Because processing manners of the UEs after the UEs receive the second information of the global model are similar, the first UE is used as an example for description in this disclosure.

Optionally, if the second information of the global model received by the first UE corresponds to a part of parameter groups of the global model, the second information of the global model further includes at least one second counter, and a parameter group corresponding to the at least one second counter is not included in the second information of the global model. It may be understood that the parameter group corresponding to the at least one second counter is a parameter group that is not updated by the access network device. In this case, if values of all or a part of the at least one second counter are different from values of the corresponding first counter, the UE does not train the global model in this round, and does not perform subsequent S303. For example, the global model includes a parameter group 1 and a parameter group 2, the second information of the global model includes the parameter group 2 but does not include the parameter group 1, and the second information of the global model further includes a value of a second counter 1 corresponding to the parameter group 1 and includes a value of a second counter 2 corresponding to the parameter group 2. The first counter that is maintained by the UE and that corresponds to the second counter 1 is a first counter 1. If a value of the second counter 1 is different from a value of the first counter 1, the UE does not perform this round of training process, and does not perform S303. This is because a value of a second counter corresponding to a parameter group that is not updated by the access network device is different from the value of the first counter maintained by the UE, which indicates that the UE does not update the parameter group that is not updated in time in a previous round of training. In this case, all or a part of parameters included in the parameter group that is not updated and maintained by the UE may be different from corresponding parameters of the parameter group maintained by the access network device. If the UE performs training based on the second information of the global model, although parameters of the parameter group that is not updated remain unchanged, these parameters need to be used in a training process. This may cause an inaccurate training result. Therefore, in this disclosure, when this case occurs, the UE may not perform training, to reduce a probability of a model error again.

For more content of S502, refer to S302 in the embodiment shown in FIG. 3.

S503: The first UE sends first local information to the access network device. Correspondingly, the access network device receives the first local information.

The first local information may indicate (or include) the first information of the first local model. In addition, if the first UE maintains only one first counter for the first local model, and the first counter corresponds to the entire first local model, the first local information further indicates the first counter (or the first local information includes a value of the first counter). Alternatively, if the first UE maintains at least one first counter for the first local model, and each first counter corresponds to one parameter group of the first local model (or the global model), the first local information further indicates all or a part of first counters maintained by the first UE (or the first local information includes all or a part of values of the first counters maintained by the first UE).

For a manner of sending the first local information by the first UE, for example, content such as a resource used to send the first local information and a protocol layer corresponding to the first local information, refer to S303 in the embodiment shown in FIG. 3.

S504: The access network device updates the global model based on M pieces of first information of M local models. The access network device obtains an updated global model based on the M pieces of first information of the M local models. For example, the access network device obtains first information of the global model based on the M pieces of first information.

Optionally, a parameter indicated by the first information of the M local models is the same as a parameter indicated by the first information of the global model. For example, all the first information of the M local models corresponds to a first parameter group of the global model, and the access network device may update the first parameter group of the global model based on the first information of the M local models, so that the first information of the obtained global model also corresponds to the first parameter group.

If the first information of the global model corresponds to a part of parameters of the global model, for example, corresponds to a first parameter group of the global model, the access network device may also perform an update process for another parameter of the global model. The update process is similar to an update process of the first parameter group. That is, another UE may send other information of a local model to the access network device, and the other information of the local model may indicate the another parameter of the global model, so that the access network device can update the another parameter of the global model. It should be noted that the UE that sends the other information of the local model to the access network device may be the M UEs, or a part of the M UEs, or UEs other than the M UEs, or a part or all of the M UEs and UEs other than the M UEs.

In an optional implementation, if there are counters (a first counter and a second counter), and parameter groups of the model are not divided (that is, the access network device and the UE each maintain one counter, and the two counters correspond to the entire model), the access network device may determine whether a value of the $i^{th}$ counter in M first counters matches a value of a second counter maintained by the access network device. The $i^{th}$ first counter is a first counter corresponding to the $i^{th}$ local model in the M local models, the $i^{th}$ local model and the $i^{th}$ first counter are maintained by the $i^{th}$ UE in the M UEs, and i is an integer ranging from 1 to M. For a manner of determining whether the values match, refer to the foregoing description. If the value of the $i^{th}$ counter matches the value of the second counter maintained by the access network device, information about the $i^{th}$ local model may participate in obtaining update information of the global model. If the value of the $i^{th}$ counter does not match the value of the second counter maintained by the access network device, the information about the $i^{th}$ local model is not used when the update information of the global model is obtained. In this disclosure, an example in which values of all the M first counters match the value of the second counter is used, and the information about the M local models may all participate in obtaining the update information of the global model.

In another optional implementation, if there are counters (a first counter and a second counter), and for example, parameter groups of a model are divided, the first local information may indicate information about the first local model and indicate at least one first counter. The at least one first counter is a first counter corresponding to a part or all of a plurality of layers of the global model (or the first local model), or the at least one first counter corresponds to a part or all of parameter groups of the global model (or the first local model). One first counter corresponds to one parameter group. Correspondingly, the access network device also maintains at least one second counter. The at least one second counter corresponds to a part or all of parameter groups of the global model, one second counter corresponds to one parameter group, and the at least one first counter one-to-one corresponds to the at least one second counter. If a value of the at least one first counter matches a value of at least one corresponding second counter, the information about

EP 4 383 151 A1

the first local model may participate in obtaining the first information of the global model. If values of a part or all of the at least one first counter do not match the values of the corresponding second counters, the information about the first local model may not participate in obtaining the first information of the global model. The access network device processes local information from another UE similarly. For example, the global model includes a parameter group 1 and a parameter group 2, and the first local information includes a value of a first counter 1 of the parameter group 1 and a value of a first counter 2 of the parameter group 2, and includes the parameter group 1 and/or the parameter group 2. A second counter corresponding to the first counter 1 is a second counter 1, and a second counter corresponding to the first counter 2 is a second counter 2. For example, if the access network device determines that a value of the first counter 2 is different from a value of the second counter 2, the access network device does not consider the parameter group 1 and the parameter group 2 that are sent by the first UE. That is, the information that is about the first local model and that is sent by the first UE does not participate in obtaining the first information of the global model. This is because even if the UE trains only the parameter group 1, the UE still needs to use a parameter included in the parameter group 2 during training. If the value of the first counter 2 is different from the value of the second counter 2, it indicates that the parameter in the parameter group 2 maintained by the UE is not updated in time. In this case, the parameter group 1 obtained through training based on the parameter group 2 may also be problematic. Therefore, the access network device does not consider all parameters from the first UE in this round of training process.

For content such as a manner in which the access network device obtains the first information of the global model, refer to S304 in the embodiment shown in FIG. 3.

S505: The access network device sends the first information of the global model. Correspondingly, a part or all of the K UEs receive the first information of the global model from the access network device.

For more content of S505, refer to S305 in the embodiment shown in FIG. 3.

In this disclosure, the counter is configured, to ensure that the local model matches an update progress of the global model, and an outdated local model does not affect performance of the global model.

The embodiment shown in FIG. 3 and the embodiment shown in FIG. 5 may be separately applied, or the embodiment shown in FIG. 3 and the embodiment shown in FIG. 5 may be applied in combination. For example, the access network device and the UE transmit information about a local model (or the local information in the embodiment shown in FIG. 5) based on the first duration, and the access network device and the UE each maintain a corresponding counter (for example, the access network device maintains a second counter, and the UE maintains a first counter). The UE may send local information to the access network device in the first duration. If the access network device receives local information from UE in the first duration, and a value of the first counter indicated by the local information matches a value of a corresponding second counter, the information about the local model included in the local information is available, and may participate in updating the global model. If the access network device does not receive the local information from the UE in the first duration, and/or the value of the first counter indicated by the local information does not match the value of the corresponding second counter, the information about the local model included in the local information is unavailable, and does not participate in updating the global model. By combining the two embodiments, double assurance can be used to improve a degree of matching of the local model and the update progress of the global model.

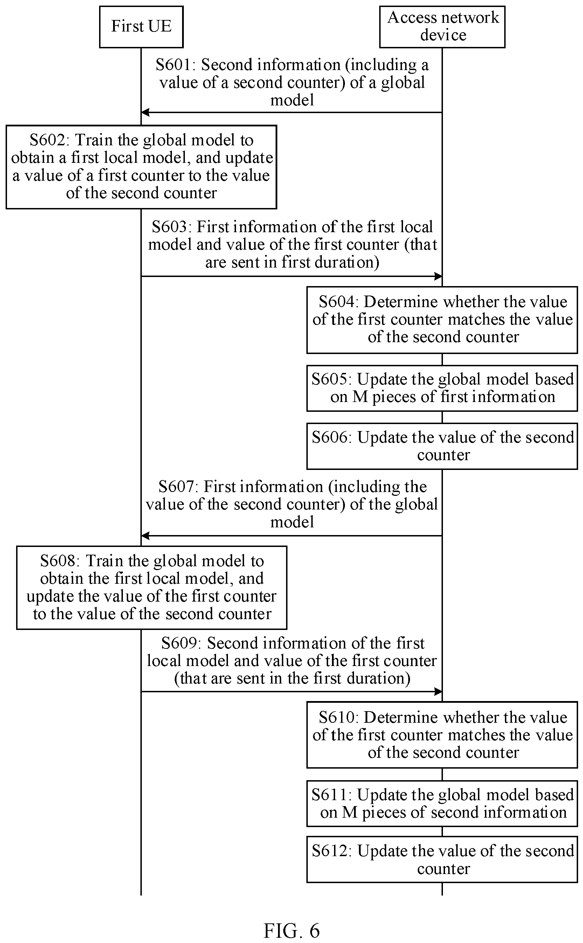

To make the solutions of this disclosure clearer, the following describes a specific example. The example is an example of applying the embodiment shown in FIG. 3 and the embodiment shown in FIG. 5 in combination. FIG. 6 is a flowchart of the example. Some values and the like in this example are examples.

S601: An access network device broadcasts second information of a global model. Correspondingly, first UE receives the second information of the global model.

For example, the second information of the global model indicates a parameter 1, a parameter 2, and a parameter 3 of the global model. For example, the global model corresponds to the three parameters in total, and the three parameters are all parameters of the global model.

Parameter information indicated by the second information of the global model is represented as a parameter set $\Phi = \{\Phi_1, \Phi_2, \Phi_3\}$, where $\Phi_1$ represents the parameter 1 (or represents a value of the parameter 1), $\Phi_2$ represents a parameter 2 (or represents a value of the parameter 2), and $\Phi_{,3}$ represents a parameter 3 (or represents a value of the parameter 3).

For example, this is the first round of training process in one training process of the global model. The access network device maintains a second counter, and the UE maintains a first counter (in the embodiment shown in FIG. 6, an example in which the access network device and the UE each maintain one counter, that is, one counter corresponds to an entire model). For example, initial values of both the first counter and the second counter are 0. This is the first round of training process, and the access network device has not updated the global model (the second information of the global model is, for example, initial information of the global model). Therefore, the access network device does not update the value of the second counter, and the value of the second counter is still 0. The second information of the global model further includes the value of the second counter, and the value is 0.

S602: The first UE trains the global model to obtain a first local model, and the first UE updates the value of the first counter to the value of the second counter, where the value is 0. For example, the first UE may obtain first information of the first local model.

For example, the first information of the first local model indicates a parameter 1, a parameter 2, and a parameter 3 of the first local model. For example, the first local model corresponds to the three parameters in total, and the three parameters are all parameters of the first local model. The parameter 1 of the first local model and the parameter 1 of the global model are of a same type, the parameter 2 of the first local model and the parameter 2 of the global model are of a same type, and the parameter 3 of the first local model and the parameter 3 of the global model are of a same type. For example, parameter information indicated by the first information of the first local model may be represented as a parameter set $\theta_e = \{\theta_{e,1}, \theta_{e,2}, \theta_{e,3}\}$, where $\theta_{e,1}$ represents the parameter 1 of the first local model, $\theta_{e,2}$ represents the parameter 2 of the first local model, and $\theta_{e,,3}$ represents the parameter 3 of the first local model.

If the second information of the global model includes the value of the second counter, the UE updates the value of the first counter to the value of the second counter. That is, the value of the first counter is still 0.

S603: The first UE sends the first information of the first local model and the value of the first counter to the access network device in first duration. Correspondingly, the access network device receives the first information of the first local model and the value of the first counter, and the first information of the first local model and the value of the first counter may be received in the first duration. In this case, the value of the first counter is 0.

If the access network device receives first information of a local model from UE beyond the first duration, the first information of the local model does not participate in updating the global model in this round, and the access network device does not need to determine whether a value of a first counter that is sent by the UE matches the value of the second counter.

S604: The access network device determines whether the value of the first counter matches the value of the second counter. For example, if the value of the first counter is the same as the value of the second counter, it is considered that the value of the first counter matches the value of the second counter; or if the value of the first counter is different from the value of the second counter, it is considered that the value of the first counter does not match the value of the second counter.

In this case, both the value of the first counter and the value of the second counter are 0. Therefore, the two values match.

S605: The access network device updates the global model based on M pieces of first information of M local models. The access network device obtains an updated global model based on the M pieces of first information of the M local models. For example, the access network device obtains first information of the global model based on the M pieces of first information. The first information of the global model is, for example, information obtained after the global model is updated.

The first information of the first local model is one of the M pieces of first information. If the value of the first counter of the first UE matches the value of the second counter, the first information of the first local model provided by the first UE may participate in updating the global model. If the value of the first counter of the first UE does not match the value of the second counter, the first information of the first local model provided by the first UE does not participate in updating the global model. In this disclosure, an example in which the first information of the first local model participates in updating the global model is used. It may be understood that the M pieces of first information are received by the access network device in the first duration, the M pieces of first information are sent by M UEs (including the first UE), the M UEs further send values of M first counters, and the values of the M first counters all match values of second counters.

For example, M=3, and each of the three parameter sets includes a parameter 1, a parameter 2, and a parameter 3. For example, in the three parameter sets, a parameter set 1 is {1, 1, 1}, a parameter set 2 is {1, 4, 1}, and a parameter set 3 is {4, 1, 1}, where the first parameter in the parameter set represents the parameter 1, the second parameter represents the parameter 2, and the third parameter represents the parameter 3. The access network device updates the global model in an arithmetic average manner. For example, the access network device can determine, based on the parameter set 1, the parameter set 2, and the parameter set 3, that a value of the parameter 1 of the global model is $\frac{1}{3} \times (1 + 1 + 4) = 2$, a value of the parameter 2 of the global model is $\frac{1}{3} \times (1 + 4 + 1) = 2$, and a value of the parameter 3 of the global model is $\frac{1}{3} \times (1 + 1 + 1) = 1$. Therefore, the access network device can determine that a parameter set of the updated global model is {2, 2, 1}, and the first information of the global model may indicate the parameter set.

S606: The access network device updates the value of the second counter. For example, if the access network device increases the value of the second counter by 1, the value of the second counter is updated to 1. The first round of training process ends.

S607: The access network device broadcasts the first information of the global model. Correspondingly, the first UE receives the first information of the global model. For example, the first information of the global model still indicates the parameter 1, the parameter 2, and the parameter 3 of the global model. The first information of the global model further includes the value of the second counter, and the value is 1.

S608: The first UE trains the global model to obtain the first local model, and the first UE updates the value of the first counter to the value of the second counter, where the value is 1. For example, the first UE may obtain second information of the first local model. For example, the second information of the first local model indicates the parameter 1, the parameter 2, and the parameter 3 of the first local model.

S609: The first UE sends the second information of the first local model and the value of the first counter to the access network device in the first duration. Correspondingly, the access network device receives the second information of the first local model and the value of the first counter, where the second information of the first local model and the value of the first counter may be received in the first duration. In this case, the value of the first counter is 1.

If the access network device receives second information of a local model from UE beyond the first duration, the second information of the local model does not participate in updating the global model in this round, and the access network device does not need to determine whether a value of a first counter that is sent by the UE matches the value of the second counter.

S610: The access network device determines whether the value of the first counter matches the value of the second counter. For example, if the value of the first counter is the same as the value of the second counter, it is considered that the value of the first counter matches the value of the second counter; or if the value of the first counter is different from the value of the second counter, it is considered that the value of the first counter does not match the value of the second counter.

In this case, both the value of the first counter and the value of the second counter are 1. Therefore, the two values match.

S611: The access network device updates the global model based on M pieces of second information of the M local models. The access network device obtains an updated global model based on the M pieces of second information of the M local models. For example, the access network device obtains third information of the global model based on the M pieces of second information, where the third information of the global model is, for example, information obtained after the global model is updated again.

S611 may also be replaced with: The access network device updates the global model based on D pieces of first information of D local models, where the D pieces of first information are from D UEs, the D UEs and the M UEs may have an intersection set or may have no intersection set, and D is a positive integer. In other words, even in one training process, UEs that send information about local models to the access network device may be the same or may be different during different rounds of training. Herein, an example in which the access network device updates the global model based on the M pieces of second information of the M local models is used.

If the value of the first counter of the first UE matches the value of the second counter, the second information of the first local model provided by the first UE may participate in updating the global model. If the value of the first counter of the first UE does not match the value of the second counter, the second information of the first local model provided by the first UE does not participate in updating the global model. In this disclosure, an example in which the second information of the first local model participates in updating the global model is used. It may be understood that the M pieces of second information are received by the access network device in the first duration, the M pieces of second information are sent by M UEs (including the first UE), the M UEs further send values of M first counters, and the values of the M first counters all match values of second counters.

For an update manner of the access network device, refer to the foregoing steps.

S612: The access network device updates the value of the second counter. For example, if the access network device increases the value of the second counter by 1, the value of the second counter is updated to 2. The second round of training process ends.

If the global model is converged, the training process may end, and the access network device may then send the third information of the global model, so that the UE obtains a latest global model. After receiving the third information of the global model, the UE may not perform training, but may use the global model. In addition, the access network device may not send the value of the second counter. For example, the access network device may reset the value of the second counter, or the UE may reset the value of the first counter. Alternatively, if the global model is not converged, the training process may continue. The access network device may also send the third information of the global model. The third information of the global model may include the value of the second counter. The UE may continue training after receiving the third information of the global model. For this process, refer to the foregoing steps.

For more implementation details of the embodiment shown in FIG. 6, refer to the description of the embodiment shown in FIG. 3 and/or the embodiment shown in FIG. 5.

It can be learned from the embodiment shown in FIG. 6 that, combining the duration solution with the counter solution is equivalent to using double assurance to improve a degree of matching of the local model and an update progress of the global model.

A communication apparatus provided in this disclosure is described based on the foregoing method embodiments.

This disclosure provides a communication apparatus. The communication apparatus includes, for example, a processing unit and a transceiver unit (or referred to as a communication unit). The processing unit may be configured to implement a processing function of the UE in the embodiment shown in FIG. 3 or the embodiment shown in FIG. 5, and the transceiver unit may be configured to implement all or a part of receiving and sending functions of the UE in the embodiment shown in FIG. 3 or the embodiment shown in FIG. 5. Alternatively, the processing unit may be configured to implement a processing function implemented by the access network device in the embodiment shown in FIG. 3 or the embodiment shown in FIG. 5, and the transceiver unit may be configured to implement all or a part of receiving and sending functions of the access network device in the embodiment shown in FIG. 3 or the embodiment shown in FIG. 5.

Optionally, the processing unit and/or the transceiver unit may be implemented by using a virtual module. For example, the processing unit may be implemented by using a software functional unit or a virtual apparatus, and the transceiver unit may be implemented by using a software functional unit or a virtual apparatus. Alternatively, the processing unit and/or the transceiver unit may be implemented by using a physical apparatus (for example, a circuit system and/or a processor). The following describes a case in which the processing unit and the transceiver unit are implemented by using a physical apparatus.

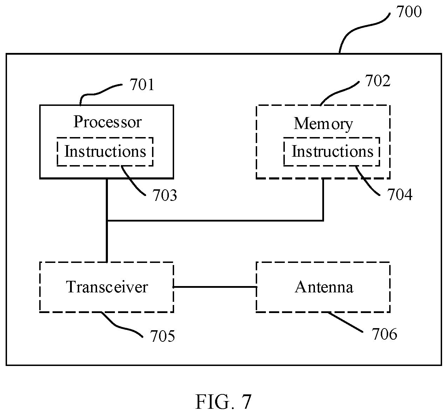

FIG. 7 is a schematic diagram of a structure of a communication apparatus according to this disclosure. The communication apparatus 700 may be the UE in the embodiment shown in FIG. 3 or the embodiment shown in FIG. 5, a circuit system of the UE, a circuit system that can be applied to the UE, or the like, and is configured to implement the method corresponding to the UE in the foregoing method embodiments. Alternatively, the communication apparatus 700 may be the access network device in the embodiment shown in FIG. 3 or the embodiment shown in FIG. 5, a circuit system of the access network device, a circuit system that can be applied to the access network device, or the like, and is configured to implement the method corresponding to the access network device in the foregoing method embodiments. For specific functions, refer to the description in the foregoing method embodiment. For example, a circuit system is a chip system.

The communication apparatus 700 includes one or more processors 701. The processor 701 may implement a specific control function. The processor 701 may be a general-purpose processor, a dedicated processor, or the like. For example, the processor 701 includes a baseband processor, a central processing unit, and the like. The baseband processor may be configured to process a communication protocol and communication data. The central processing unit may be configured to control the communication apparatus 700, execute a software program, and/or process data. Different processors may be independent components, or may be disposed on one or more processing circuits, for example, integrated into one or more application-specific integrated circuits.

Optionally, the communication apparatus 700 includes one or more memories 702, configured to store instructions 704. The instructions 704 may be run on the processor, so that the communication apparatus 700 performs the method described in the foregoing method embodiments. Optionally, the memory 702 may further store data. The processor and the memory may be separately disposed, or may be integrated together.

Optionally, the communication apparatus 700 may store instructions 703 (which may also be referred to as code or a program sometimes), and the instructions 703 may be run on the processor, so that the communication apparatus 700 performs the method described in the foregoing embodiments. The processor 701 may store data.

For example, the processing unit is implemented by using one or more processors 701, or the processing unit is implemented by using one or more processors 701 and one or more memories 702, or the processing unit is implemented by using one or more processors 701, one or more memories 702, and the instructions 703.

Optionally, the communication apparatus 700 may further include a transceiver 705 and an antenna 706. The transceiver 705 may be referred to as a transceiver unit, a transceiver machine, a transceiver circuit, an input/output interface, or the like, and is configured to implement a transceiver function of the communication apparatus 700 by using the antenna 706. For example, the transceiver unit is implemented by using the transceiver 705, or the transceiver unit is implemented by using the transceiver 705 and the antenna 706.

Optionally, the communication apparatus 700 may further include one or more of the following components: a wireless communication module, an audio module, an external memory interface, an internal memory, a universal serial bus (universal serial bus, USB) interface, a power management module, an antenna, a speaker, a microphone, an input/output module, a sensor module, a motor, a camera, a display, or the like. It may be understood that, in some embodiments, the communication apparatus 700 may include more or fewer components, or some components are integrated, or some components are split. These components can be hardware, software, or a combination implementation of software and hardware.

The processor 701 and the transceiver 705 described in this disclosure may be implemented on an integrated circuit (integrated circuit, IC), an analog IC, a radio frequency integrated circuit (radio frequency identification, RFID), a mixed-signal IC, an application-specific integrated circuit (application-specific integrated circuit, ASIC), a printed circuit board (printed circuit board, PCB), an electronic device, or the like. The communication apparatus described in this specification may be an independent device (for example, an independent integrated circuit or a mobile phone), or may be a part of a larger device (for example, a module that can be embedded into another device). For details, refer to the description of the UE and the access network device in the foregoing embodiments. Details are not described herein again.

This disclosure provides a terminal device. The terminal device may be used in the foregoing embodiments. The terminal device includes corresponding means (means), units, and/or circuits for implementing the functions of the UE in the embodiment shown in FIG. 3 or the embodiment shown in FIG. 5. For example, the terminal device includes a transceiver module (or referred to as a transceiver unit), configured to support the terminal device in implementing a transceiver function, and a processing module (or referred to as a processing unit), configured to support the terminal device in processing a signal.

All or some of the technical solutions provided in this disclosure may be implemented by using software, hardware, firmware, or any combination thereof. When software is used to implement the embodiments, all or a part of the embodiments may be implemented in a form of a computer program product. The computer program product includes one or more computer instructions. When the computer program instructions are loaded and executed on a computer, the procedure or functions according to this disclosure are all or partially generated. The computer may be a general-purpose computer, a special-purpose computer, a computer network, an access network device, a terminal device, an AI node, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk drive, or a magnetic tape), an optical medium (for example, a digital video disc (digital video disc, DVD)), a semiconductor medium, or the like.

The foregoing description is merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of this disclosure shall be subject to the protection scope of the claims.

**Claims**

1. A communication method, comprising:

    receiving M pieces of first information of M local models from M terminal devices, wherein the M terminal devices one-to-one correspond to the M local models, the M local models one-to-one correspond to the M pieces of first information, the M pieces of first information of the M local models are information received in first duration, and M is a positive integer; and
    sending first information of a global model to K terminal devices, wherein K is a positive integer, the first information of the global model is information obtained after the global model is updated, and the M pieces of first information of the M local models are used to update the global model.

2. The method according to claim 1, wherein the method further comprises:

    receiving N pieces of first information of N local models, wherein the N pieces of first information of the N local models are information received beyond the first duration, and N is a positive integer; and
    discarding the N pieces of first information of the N local models, or skipping using the N pieces of first information of the N local models to update the global model.

3. The method according to claim 1 or 2, wherein a start moment of the first duration is the $H1^{th}$ time unit after a time unit in which second information of the global model is sent last time starts or a time unit in which training of the global model starts, a length of the first duration is H2 time units, H1 is greater than or equal to 0, and H2 is greater than 0.

4. The method according to claim 3, wherein H1 or H2 is predefined or preconfigured.

5. The method according to any one of claims 1 to 4, wherein first information of a first local model in the M pieces of first information of the M local models is from a first terminal device in the M terminal devices, wherein

the first information of the first local model indicates parameter information of the first local model; or

the first information of the first local model indicates a difference between the parameter information of the first local model and first parameter information, and the first parameter information is parameter information that is of the global model and that is indicated to the first terminal device last time or parameter information of the global model before the global model is updated.

6. The method according to any one of claims 1 to 5, wherein

the first information of the global model indicates parameter information of the global model; or

the first information of the global model indicates a difference between current parameter information of the global model and the first parameter information, and the first parameter information is parameter information that is of the global model and that is indicated last time or parameter information of the global model before the global model is updated.

7. The method according to any one of claims 1 to 6, wherein the K terminal devices are comprised in one terminal device group.

8. The method according to claim 7, wherein

values of fourth parameters corresponding to terminal devices comprised in the terminal device group all fall within a first range, and the first range corresponds to the global model; or

a difference between a value of a fourth parameter corresponding to a terminal device comprised in the terminal device group and a first value is less than or equal to a first threshold, and the first value corresponds to the global model.

9. A communication method, comprising:

receiving M pieces of first information of M local models from M terminal devices, wherein the M terminal devices one-to-one correspond to the M local models, the M local models one-to-one correspond to the M pieces of first information, first information of each local model corresponds to a first counter, and a value of each first counter matches a value of a second counter; and

sending first information of a global model to K terminal devices, wherein K is a positive integer, the first information of the global model is information obtained after the global model is updated, the M pieces of first information of the M local models are used to update the global model, and the second counter is a counter corresponding to the global model.

10. The method according to claim 9, wherein

the first information of the global model indicates parameter information of the global model; or

the first information of the global model indicates a difference between second parameter information of the global model and first parameter information, and the first parameter information is parameter information that is of the global model and that is indicated last time or parameter information of the global model before the global model is updated.

11. A communication method, comprising:

performing training by using a global model, to obtain first information of a first local model;

sending the first information of the first local model to an access network device in first duration; and

receiving first information of the global model from the access network device, wherein the first information of the global model is information obtained after the global model is updated.

12. The method according to claim 11, wherein a start moment of the first duration is the H1th time unit after a time unit in which second information of the global model is received last time starts or a time unit in which training of the global model starts, a length of the first duration is H2 time units, H1 is greater than or equal to 0, and H2 is greater than 0.

13. The method according to claim 12, wherein H1 or H2 is predefined or preconfigured.

**14.** The method according to any one of claims 11 to 13, wherein

the first information of the first local model indicates parameter information of the first local model; or
the first information of the first local model indicates a difference between the parameter information of the first local model and first parameter information, and the first parameter information is parameter information that is of the global model and that is indicated last time or parameter information of the global model before the global model is updated.

**15.** The method according to any one of claims 11 to 14, wherein

the first information of the global model indicates parameter information of the global model; or
the first information of the global model indicates a difference between current parameter information of the global model and the first parameter information, and the first parameter information is parameter information that is of the global model and that is indicated last time or parameter information of the global model before the global model is updated.

**16.** The method according to any one of claims 11 to 15, wherein the method further comprises:

determining that a value of a fourth parameter falls within a first range, wherein the first range corresponds to the global model;
determining that a difference between the value of the fourth parameter and a first value is less than or equal to a first threshold, wherein the first value corresponds to the global model; or
determining, based on a classification network, that a first terminal device belongs to a first class, wherein the first class is applicable to the global model.

**17.** A communication method, comprising:

performing training by using a global model, to obtain first information of a first local model;
sending first local information to an access network device, wherein the first local information indicates the first information of the first local model and indicates a first counter, and the first counter identifies the first local model; and
receiving first information of the global model from the access network device, wherein the first information of the global model is information obtained after the global model is updated.

**18.** The method according to claim 17, wherein

the first information of the global model indicates parameter information of the global model; or
the first information of the global model indicates a difference between current parameter information of the global model and first parameter information, and the first parameter information is parameter information that is of the global model and that is indicated last time or parameter information of the global model before the global model is updated.

**19.** A communication apparatus, configured to implement the method according to any one of claims 1 to 8, or configured to implement the method according to claim 9 or 10, or configured to implement the method according to any one of claims 11 to 16, or configured to implement the method according to claim 17 or 18.

**20.** A communication apparatus, comprising a processor and a memory, wherein the memory is coupled to the processor, and the processor is configured to perform the method according to any one of claims 1 to 8, or configured to perform the method according to claim 9 or 10, or configured to perform the method according to any one of claims 11 to 16, or configured to perform the method according to claim 17 or 18.

**21.** A computer-readable storage medium, wherein the computer-readable storage medium is configured to store a computer program, and when the computer program is run on a computer, the computer is enabled to perform the method according to any one of claims 1 to 8, or the computer is enabled to perform the method according to claim 9 or 10, or the computer is enabled to perform the method according to any one of claims 11 to 16, or the computer is enabled to perform the method according to claims 17 or 18.

FIG. 1

FIG. 2A

FIG. 2B

FIG. 2C

FIG. 2D

FIG. 2E

FIG. 2F

FIG. 2G

EP 4 383 151 A1

| First UE | | Access network device |

S301: Second information of a global model

S302: Train the global model to obtain a first local model

S303: First information of the first local model (sent in first duration)

S304: Update the global model based on M pieces of first information of M local models

S305: First information of the global model

FIG. 3

$y = f(\sum_{i=0}^{n} w_i x_i + b)$

Neuron

$w_0 x_0$

$w_1 x_1$

$w_n x_n$

$y$

FIG. 4A

FIG. 4B

FIG. 4C

FIG. 4D

FIG. 5

| First UE | | Access network device |
|---|---|---|

S601: Second information (including a value of a second counter) of a global model

S602: Train the global model to obtain a first local model, and update a value of a first counter to the value of the second counter

S603: First information of the first local model and value of the first counter (that are sent in first duration)

S604: Determine whether the value of the first counter matches the value of the second counter

S605: Update the global model based on M pieces of first information

S606: Update the value of the second counter

S607: First information (including the value of the second counter) of the global model

S608: Train the global model to obtain the first local model, and update the value of the first counter to the value of the second counter

S609: Second information of the first local model and value of the first counter (that are sent in the first duration)

S610: Determine whether the value of the first counter matches the value of the second counter

S611: Update the global model based on M pieces of second information

S612: Update the value of the second counter

FIG. 6

700

701
┌─────────────────┐
│    Processor    │
│ ┌─────────────┐ │
│ │Instructions │ │
│ └─────────────┘ │
└─────────────────┘
703

702
┌─────────────────┐
│     Memory      │
│ ┌─────────────┐ │
│ │Instructions │ │
│ └─────────────┘ │
└─────────────────┘
704

┌─────────────────┐       ┌─────────────────┐
│   Transceiver   │───────│     Antenna     │
└─────────────────┘       └─────────────────┘
705                        706

FIG. 7

## INTERNATIONAL SEARCH REPORT

| International application No. |
| --- |
| **PCT/CN2022/115402** |

**A.    CLASSIFICATION OF SUBJECT MATTER**

G06N 20/00(2019.01)i;   G06N 20/20(2019.01)i;   G06F 30/27(2020.01)i

According to International Patent Classification (IPC) or to both national classification and IPC

**B.    FIELDS SEARCHED**

Minimum documentation searched (classification system followed by classification symbols)

G06N 20/-; G06N 99/-; G06F 9/-; G06F 30/-

Documentation searched other than minimum documentation to the extent that such documents are included in the fields searched

Electronic data base consulted during the international search (name of data base and, where practicable, search terms used)

CNABS, CNTXT, CNKI, VEN, EPTXT, WOTXT, USTXT, IEEE: 联邦学习, 联合学习, 机器学习, 本地, 局部, 部分, 全局, 模型, 更新, 同步, 时间, 计时, 周期, 间隔, 时长, 期限, 最长, 截止, 等待, 接收, 上传, 计时器, 计数器, 定时器, 次数, 迭代, 延迟, 掉队; federated learning, global, model, local, update, synchron+, time, counter, , timer, straggler

**C.    DOCUMENTS CONSIDERED TO BE RELEVANT**

| Category* | Citation of document, with indication, where appropriate, of the relevant passages | Relevant to claim No. |
| --- | --- | --- |
| X | CN 107944566 A (CLOUDBRAIN INC.) 20 April 2018 (2018-04-20) description, paragraphs [0142]-[0147] and [0171]-[0207] | 1-8, 11-16, 19-21 |
| Y | CN 107944566 A (CLOUDBRAIN INC.) 20 April 2018 (2018-04-20) description, paragraphs [0142]-[0147] and [0171]-[0207] | 9-10, 17-18 |
| Y | CN 111444021 A (UNIVERSITY OF ELECTRONIC SCIENCE AND TECHNOLOGY OF CHINA) 24 July 2020 (2020-07-24) description, paragraphs [0075]-[0083] | 9-10, 17-18 |
| A | CN 110442457 A (PEKING UNIVERSITY SHENZHEN GRADUATE SCHOOL) 12 November 2019 (2019-11-12) entire document | 1-21 |
| A | CN 113159329 A (GUANGDONG OPPO MOBILE COMMUNICATIONS CO., LTD.) 23 July 2021 (2021-07-23) entire document | 1-21 |
| A | US 2020027033 A1 (ADOBE INC.) 23 January 2020 (2020-01-23) entire document | 1-21 |

☐ Further documents are listed in the continuation of Box C.        ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **18 November 2022** | **30 November 2022** |

| Name and mailing address of the ISA/CN | Authorized officer |
| --- | --- |
| **China National Intellectual Property Administration (ISA/ CN) No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/115402**

| Patent document cited in search report | | | Publication date (day/month/year) | Patent family member(s) | | | Publication date (day/month/year) |
|---|---|---|---|---|---|---|---|
| CN | 107944566 | A | 20 April 2018 | WO | 2019104713 | A1 | 06 June 2019 |
| | | | | CN | 107944566 | B | 22 December 2020 |
| CN | 111444021 | A | 24 July 2020 | None | | | |
| CN | 110442457 | A | 12 November 2019 | None | | | |
| CN | 113159329 | A | 23 July 2021 | CN | 113052329 | B | 27 May 2022 |
| US | 2020027033 | A1 | 23 January 2020 | US | 11170320 | B2 | 09 November 2021 |

Form PCT/ISA/210 (patent family annex) (January 2015)

**EP 4 383 151 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111005070